# EUROPEAN PATENT APPLICATION

(11) **EP 4 831 222 A1**
(43) Date of publication of application: **28.10.2026**
(21) Application number: 24907357.8
(22) Date of filing: 16.12.2024
(51) Int. Cl.: C08G 64/04, C08G 63/64, C08G 63/133, C08G 63/137, H01L 23/14, H05K 1/03

(54) **RESIN, ELECTRONIC SUBSTRATE MATERIAL, COATING LIQUID COMPOSITION, FILM, SHEET, ELECTRONIC SUBSTRATE, AND RESIN PRODUCTION METHOD**

(30) Priority: 22.12.2023 JP 2023217278
(71) Applicant: Idemitsu Kosan Co.,Ltd., Tokyo 100-8321 (JP)
(72) Inventor: NAKAMURA Masato, Tokyo 100-8321 (JP)
(74) Representative: Gille Hrabal Partnerschaftsgesellschaft mbB Patentanwälte
(86) International application number: PCT/JP2024/044373
(87) International publication number: WO 2025/134972

(57) **Abstract**

An electronic substrate material contains: a first resin, in which the first resin is at least one resin selected from the group consisting of polycarbonate, polyester, and polyester polycarbonate, and the first resin includes a structural unit represented by a formula (A1) below and at least one structural unit selected from the group consisting of structural units represented by formulae (B1), (C1), and (D1) below.

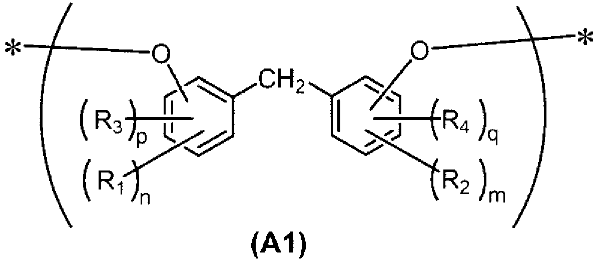

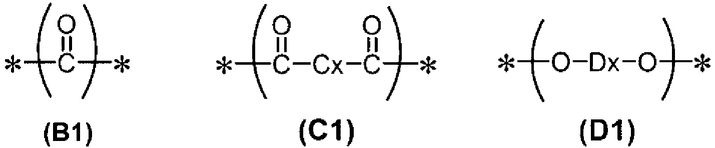

## Description

### TECHNICAL FIELD

The present invention relates to a resin, an electronic substrate material, a coating liquid composition, a film, a sheet, an electronic substrate, and a resin production method.

### BACKGROUND ART

Next-generation high-speed communication technologies known as 5G or 6G have characteristics such as "high speed and large capacity", "massive simultaneous connectivity," and "ultra-low latency", and have been introduced into various communication networks in fields such as the electrical and electronic equipment field, the mobility field including automobiles, and the medical field, thereby bringing about changes in the economy and society. Electronic circuit boards and semiconductor package substrates (hereinafter referred to as "electronic substrates") used in electronic devices such as communication devices in such fields also face various challenges in improving the performance of the electronic devices. One major challenge is that, with an increase in the amount of information communication, frequencies used for communication have become higher. Due to such higher frequencies, in materials used for known electronic substrates, transmission loss, which is the proportion of electrical signal energy lost through conversion into unnecessary energy such as thermal energy, increases, thereby causing problems of energy loss and heat generation from the substrate.

Transmission loss consists of two components: conductor loss and dielectric loss. Dielectric loss is proportional to the square root of the dielectric constant (Dk) of a dielectric and to the dissipation factor (Df) of the dielectric. Thus, in order to reduce, for instance, transmission loss in substrates such as electronic substrates using an insulating material, it is necessary to reduce the dielectric constant and the dissipation factor of a material used as the insulating material. In addition, in order to reduce conductor loss, there is a trend toward reducing the roughness of an interface between a substrate and metal wiring. Accordingly, the insulating material is required to have improved adhesion to metal foil and metal plating.

Further, electronic substrate materials are required to exhibit not only reduced transmission loss but also various other properties. Examples of such properties include high heat resistance capable of withstanding high-temperature solder reflow, and low thermal expansion for suppressing warpage of a substrate caused by a difference in thermal expansion coefficient between a copper circuit and an insulating layer. Further, when the electronic substrate material as an insulating material is used for applications in which it is applied to and molded on a substrate, the properties required of the electronic substrate material include high solvent solubility, low solution viscosity, and filler dispersibility. Furthermore, when the electronic substrate material is used for forming thin films employed in the lamination of wiring layers, the properties required of the electronic substrate material include high solvent solubility, low viscosity, filler dispersibility, and small variations in dielectric properties under operating conditions such as temperature and humidity.

Resins such as thermoplastic resins including liquid crystal polymers, polyphenylene ethers, polyimides, and fluororesins, as well as thermosetting resins including epoxy resins and maleimide resins, have been improved and developed for various applications of electronic substrates in which the resins are used as the insulating material.

Among these resins, polycarbonate resins have been used as materials for molded products in various industrial fields because they exhibit excellent properties such as mechanical properties, thermal properties, electrical properties, and transparency. However, in order to use the polycarbonate resins for the above-described electronic substrates for high-frequency applications, typical bisphenol A polycarbonate has poor solubility in organic solvents and poor solution stability, and therefore is difficult to apply to the formation of insulating coating solutions for fine wiring or to the molding of thin insulating films.

For example, Patent Literature 1 describes a polycarbonate resin or a polyarylate resin having a predetermined molecular structure as a resin used in a photoconductive layer.

For example, Patent Literature 2 describes that a copolycarbonate polymer derived from a bisphenol of a bis(2-hydroxyaryl) type and at least one other bisphenol has high solubility in non-halogenated solvents, exhibits excellent solution stability, strength, and abrasion resistance, and is suitable for fields requiring mechanical strength, such as electrophotographic photoreceptor binder resins.

For example, Patent Literature 3 describes a resin composition obtained by mixing two types of polycarbonate resins having specific molecular structures, which is suitable as a material for optical elements.

### CITATION LIST

### PATENT LITERATURE(S)

Patent Literature 1: WO 2015/097903 A1
Patent Literature 2: JP H09-316186 A
Patent Literature 3: JP H01-043559 A

### SUMMARY OF THE INVENTION

### PROBLEM(S) TO BE SOLVED BY THE INVENTION

However, Patent Literature 1, Patent Literature 2, and Patent Literature 3 neither describe nor suggest properties required of polycarbonate resins and polyarylate resins when used as electronic substrate materials, such as dielectric properties and thermal properties.

An object of the invention is to provide: a resin and an electronic substrate material having dielectric properties enabling use as an electronic substrate material and exhibiting excellent solubility in non-halogenated solvents; a coating liquid composition, a film, a sheet, and an electronic substrate containing the resin or the electronic substrate material; and a method for producing the resin.

### MEANS FOR SOLVING THE PROBLEM(S)

As a result of intensive studies, the inventors have found that a resin, a copolymer, and an electronic substrate material each including a specific structural unit have dielectric properties enabling use as an electronic substrate material and exhibit excellent solubility in non-halogenated solvents. Accordingly, the gist of the invention resides in [Configuration 1] to [Configuration 50] as below.

[Configuration 1] An electronic substrate material, containing: a first resin, in which the first resin is at least one resin selected from the group consisting of polycarbonate, polyester, and polyester polycarbonate, and the first resin includes a structural unit represented by a formula (A1) below and at least one structural unit selected from the group consisting of structural units represented by formulae (B1), (C1), and (D1) below. 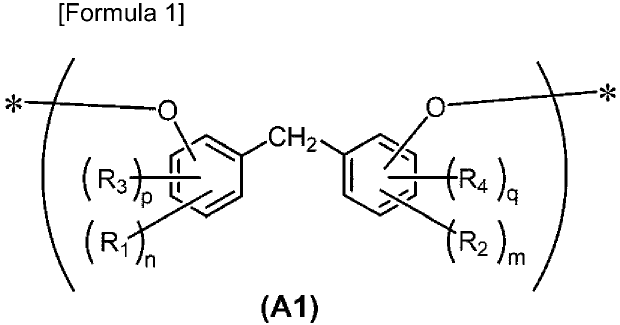 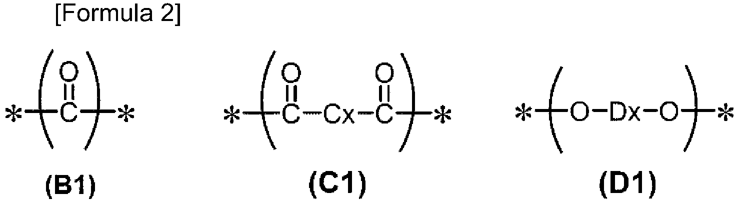 In the formula (A1):
   R₁ and R₂ are each independently a substituted or unsubstituted cycloalkyl group having 3 to 20 ring carbon atoms;
   n represents 1, 2, 3, or 4, and a plurality of R₁ are identical or different from each other;
   m represents 1, 2, 3, or 4, and a plurality of R₂ are identical or different from each other;
   R₃ and R₄ are each independently a substituted or unsubstituted alkyl group having 1 to 20 carbon atoms, a substituted or unsubstituted alkenyl group having 2 to 10 carbon atoms, a substituted or unsubstituted alkynyl group having 2 to 10 carbon atoms, a substituted or unsubstituted aryl group having 6 to 14 ring carbon atoms, a substituted or unsubstituted alkoxy group having 1 to 20 carbon atoms, a substituted or unsubstituted cycloalkoxy group having 3 to 20 ring carbon atoms, a substituted or unsubstituted aryloxy group having 6 to 14 ring carbon atoms, a substituted or unsubstituted aralkyl group having 7 to 20 carbon atoms, a substituted or unsubstituted aralkyloxy group having 7 to 20 carbon atoms, a substituted or unsubstituted heteroaryl group having 5 to 14 ring atoms, a halogen atom, a nitro group, an aldehyde group, a cyano group, or a carboxy group;
   p represents 0, 1, 2, or 3, and a plurality of R₃ are identical or different from each other;
   q represents 0, 1, 2, or 3, and a plurality of R₄ are identical or different from each other;
   a sum of n and p is 1, 2, 3, or 4;
   a sum of m and q is 1, 2, 3, or 4; and
   the structural unit represented by the formula (B1) is different from a carbonyl group in the formula (C1);
   in the formula (C1):
      Cx is a divalent group including at least one group selected from the group consisting of a substituted or unsubstituted divalent aromatic hydrocarbon group, a substituted or unsubstituted divalent cyclic aliphatic hydrocarbon group, and a substituted or unsubstituted divalent acyclic aliphatic hydrocarbon group;
      in the formula (D1):
         Dx is a divalent group including at least one group selected from the group consisting of a substituted or unsubstituted divalent aromatic hydrocarbon group, a substituted or unsubstituted divalent cyclic aliphatic hydrocarbon group, and a substituted or unsubstituted divalent acyclic aliphatic hydrocarbon group;
         the structural unit represented by the formula (A1) and the structural unit represented by the formula (D1) are different from each other;
         substituents for a "substituted or unsubstituted" group are bonded to each other to form a monocyclic ring, bonded to each other to form a fused ring, or not bonded to each other;
         each * in the formulae (A1), (B1), (C1) and (D1) represents a bond;
         when the first resin includes a plurality of structural units represented by the formula (A1), the plurality of structural units represented by the formula (A1) are identical or different from each other;
         when the first resin includes a plurality of structural units represented by the formula (C1), the plurality of structural units represented by the formula (C1) are identical or different from each other; and
         when the first resin includes a plurality of structural units represented by the formula (D1), the plurality of structural units represented by the formula (D1) are identical or different from each other.
[Configuration 2] The electronic substrate material according to Configuration 1, in which the first resin is a resin including the structural units represented by the formulae (A1) and (B1).
[Configuration 3] The electronic substrate material according to Configuration 1, in which the first resin is a resin including the structural units represented by the formulae (A1), (B1), and (D1).
[Configuration 4] The electronic substrate material according to any one of Configurations 1 to 3, in which a ratio a:d of a mole fraction a of the structural unit represented by the formula (A1) to a mole fraction d of the structural unit represented by the formula (D1) in the first resin is in a range from 5:95 to 100:0.
[Configuration 5] The electronic substrate material according to Configuration 3 or 4, in which a ratio a:d of a mole fraction a of the structural unit represented by the formula (A1) to a mole fraction d of the structural unit represented by the formula (D1) in the first resin is in a range from 10:90 to 50:50.
[Configuration 6] The electronic substrate material according to any one of Configurations 1 to 5, in which the structural unit represented by the formula (A1) is represented by a formula (A10) below. 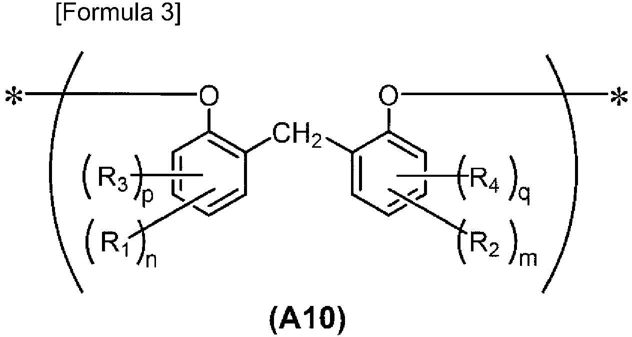 In the formula (A10), R₁, R₂, R₃, R₄, n, m, p, q, and * respectively represent the same as R₁, R₂, R₃, R₄, n, m, p, q, and * in the formula (A1).
[Configuration 7] The electronic substrate material according to any one of Configurations 1 to 6, in which n and m are each 1.
[Configuration 8] The electronic substrate material according to any one of Configurations 1 to 7, in which the structural unit represented by the formula (A1) is represented by a formula (A11) below. 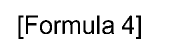 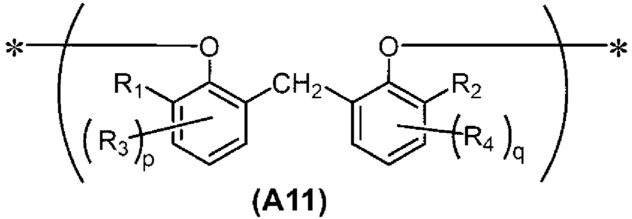 In the formula (A11), R₁, R₂, R₃, R₄, p, q, and * respectively represent the same as R₁, R₂, R₃, R₄, p, q, and * in the formula (A1).
[Configuration 9] The electronic substrate material according to any one of Configurations 1 to 8, in which p and q are each 1.
[Configuration 10] The electronic substrate material according to any one of Configurations 1 to 9, in which the structural unit represented by the formula (A1) is represented by a formula (A12) below. 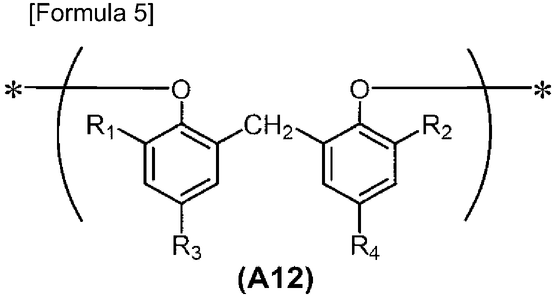 In the formula (A12), R₁, R₂, R₃, R₄, and * respectively represent the same as R₁, R₂, R₃, R₄, and * in the formula (A1).
[Configuration 11] The electronic substrate material according to any one of Configurations 1 to 10, in which the structural unit represented by the formula (D1) is represented by a formula (D2) below. 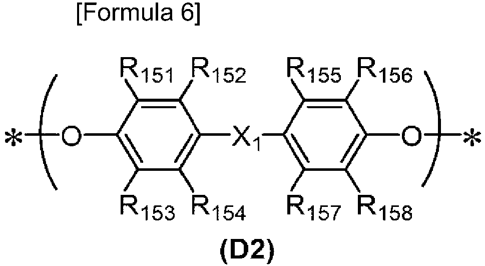 In the formula (D2):
   R₁₅₁ to R₁₅₈ are each independently selected from the group consisting of a hydrogen atom, a halogen atom, a substituted or unsubstituted alkyl group having 1 to 18 carbon atoms, a substituted or unsubstituted alkoxy group having 1 to 18 carbon atoms, a substituted or unsubstituted cycloalkyl group having 6 to 20 ring carbon atoms, a substituted or unsubstituted cycloalkoxy group having 6 to 20 ring carbon atoms, a substituted or unsubstituted alkenyl group having 2 to 10 carbon atoms, a substituted or unsubstituted aryl group having 6 to 14 ring carbon atoms, a substituted or unsubstituted aryloxy group having 6 to 14 ring carbon atoms, a substituted or unsubstituted aralkyl group having 7 to 20 carbon atoms, a substituted or unsubstituted aralkyloxy group having 7 to 20 carbon atoms, a nitro group, an aldehyde group, a cyano group, and a carboxy group;
   X₁ is (i) a single bond; (ii) a group selected from the group consisting of a substituted or unsubstituted alkylene group having 1 to 28 carbon atoms, a substituted or unsubstituted alkylidene group having 2 to 28 carbon atoms, a substituted or unsubstituted cycloalkylene group having 5 to 15 ring carbon atoms, a substituted or unsubstituted cycloalkylidene group having 3 to 26 ring carbon atoms, a substituted or unsubstituted arylene group having 6 to 20 ring carbon atoms, -S-, - SO-, -SO₂-, -O-, and -CO-; or (iii) a divalent group formed by linking two or more groups selected from the group described in (ii) above; and
   each * represents a bond.
[Configuration 12] The electronic substrate material according to Configuration 11, in which a substituted or unsubstituted cycloalkylidene group having 5 to 15 ring carbon atoms.
[Configuration 13] The electronic substrate material according to Configuration 11 or 12, in which R₁₅₁ to R₁₅₈ are each independently a hydrogen atom, a substituted or unsubstituted alkyl group having 1 to 18 carbon atoms, or a substituted or unsubstituted cycloalkyl group having 6 to 20 ring carbon atoms.
[Configuration 14] The electronic substrate material according to any one of Configurations 1 to 10, in which the structural unit represented by the formula (D1) is represented by a formula (D3) below. 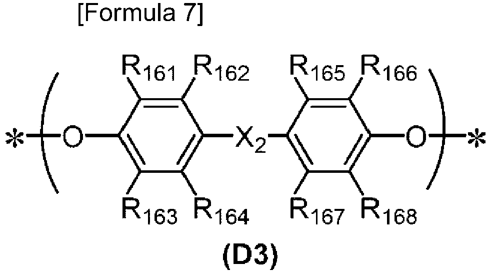 In the formula (D3):
   X₂ is (i) a single bond, or (ii) a substituted or unsubstituted divalent organic group having 7 to 12 carbon atoms;
   R₁₆₁ to R₁₆₈ are each independently a hydrogen atom, or a substituted or unsubstituted organic group having 1 to 10 carbon atoms; and
   each * represents a bond.
[Configuration 15] The electronic substrate material according to any one of Configurations 1 to 14, in which a reduced viscosity of the first resin is 0.80 dL/g or less, and the reduced viscosity of the first resin is a reduced viscosity at 20 degrees C of a solution having a concentration of 0.5 g/dL, in which methylene chloride is used as a solvent and the first resin is used as a solute.
[Configuration 16] The electronic substrate material according to any one of Configurations 1 to 15, in which the first resin includes a repeating unit represented by a formula (PC-AB1) below in which the structural unit represented by the formula (A1) is bonded to the structural unit represented by the formula (B1), and consecutive repeating units each represented by the formula (PC-AB1) are absent in the first resin. 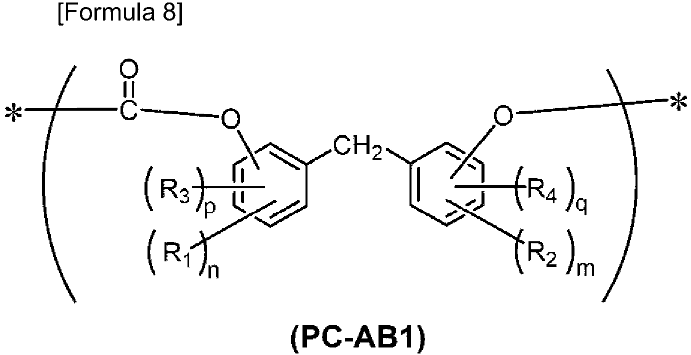 In the formula (PC-AB1), R₁, R₂, R₃, R₄, m, n, p, and q respectively represent the same as R₁, R₂, R₃, R₄, m, n, p, and q in the formula (A1), and each * represents a bond.
[Configuration 17] The electronic substrate material according to any one of Configurations 1 to 16, in which the first resin is a polycarbonate resin.
[Configuration 18] The electronic substrate material according to any one of Configurations 1 to 17, in which a content ratio of the first resin in the electronic substrate material is 50 mass% or more.
[Configuration 19] The electronic substrate material according to any one of Configurations 1 to 18, in which a dielectric constant Dk of the first resin is 2.70 or less.
[Configuration 20] The electronic substrate material according to any one of Configurations 1 to 19, in which a dissipation factor Df of the first resin is 0.00300 or less.
[Configuration 21] The electronic substrate material according to any one of Configurations 1 to 20, in which a viscosity-average molecular weight Mv of the first resin in the electronic substrate material is in a range from 1,000 to 30,000.
[Configuration 22] A coating liquid composition, containing: the electronic substrate material according to any one of Configurations 1 to 21; and a non-halogenated solvent.
[Configuration 23] A film containing the electronic substrate material according to any one of Configurations 1 to 21.
[Configuration 24] A sheet containing the electronic substrate material according to any one of Configurations 1 to 21.
[Configuration 25] An electronic substrate containing the electronic substrate material according to any one of Configurations 1 to 21.
[Configuration 26] A resin that is at least one resin selected from the group consisting of polycarbonate, polyester, and polyester polycarbonate, the resin including: a structural unit represented by a formula (A1) below and at least one structural unit selected from the group consisting of structural units represented by formulae (B1), (C1), and (D1) below. 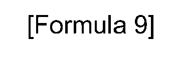 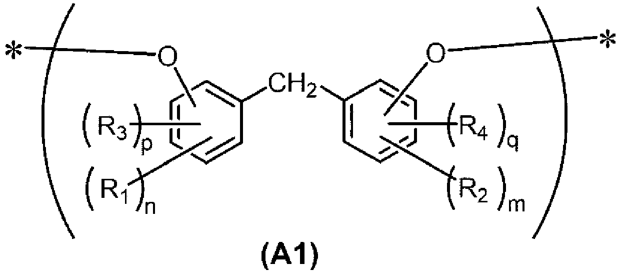 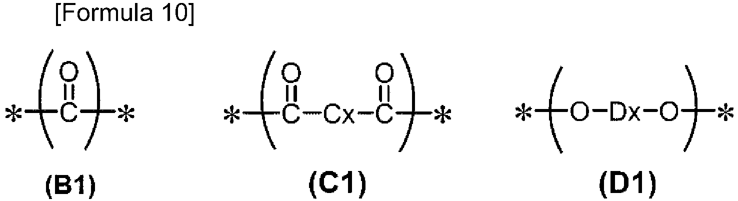 In the formula (A1):
   R₁ and R₂ are each independently a substituted or unsubstituted cycloalkyl group having 3 to 20 ring carbon atoms;
   n represents 1, 2, 3, or 4, and a plurality of R₁ are identical or different from each other;
   m represents 1, 2, 3, or 4, and a plurality of R₂ are identical or different from each other;
   R₃ and R₄ are each independently a substituted or unsubstituted alkyl group having 1 to 20 carbon atoms, a substituted or unsubstituted alkenyl group having 2 to 10 carbon atoms, a substituted or unsubstituted alkynyl group having 2 to 10 carbon atoms, a substituted or unsubstituted aryl group having 6 to 14 ring carbon atoms, a substituted or unsubstituted alkoxy group having 1 to 20 carbon atoms, a substituted or unsubstituted cycloalkoxy group having 3 to 20 ring carbon atoms, a substituted or unsubstituted aryloxy group having 6 to 14 ring carbon atoms, a substituted or unsubstituted aralkyl group having 7 to 20 carbon atoms, a substituted or unsubstituted aralkyloxy group having 7 to 20 carbon atoms, a substituted or unsubstituted heteroaryl group having 5 to 14 ring atoms, a halogen atom, a nitro group, an aldehyde group, a cyano group, or a carboxy group;
   p represents 0, 1, 2, or 3, and a plurality of R₃ are identical or different from each other;
   q represents 0, 1, 2, or 3, and a plurality of R₄ are identical or different from each other;
   a sum of n and p is 1, 2, 3, or 4;
   a sum of m and q is 1, 2, 3, or 4; and
   the structural unit represented by the formula (B1) is different from a carbonyl group in the formula (C1);
   in the formula (C1):
      Cx is a divalent group including at least one group selected from the group consisting of a substituted or unsubstituted divalent aromatic hydrocarbon group, a substituted or unsubstituted divalent cyclic aliphatic hydrocarbon group, and a substituted or unsubstituted divalent acyclic aliphatic hydrocarbon group;
      in the formula (D1):
         Dx is a divalent group including at least one group selected from the group consisting of a substituted or unsubstituted divalent aromatic hydrocarbon group, a substituted or unsubstituted divalent cyclic aliphatic hydrocarbon group, and a substituted or unsubstituted divalent acyclic aliphatic hydrocarbon group;
         the structural unit represented by the formula (A1) and the structural unit represented by the formula (D1) are different from each other;
         substituents for a "substituted or unsubstituted" group are bonded to each other to form a monocyclic ring, bonded to each other to form a fused ring, or not bonded to each other;
         each * in the formulae (A1), (B1), (C1) and (D1) represents a bond;
         when the resin includes a plurality of structural units represented by the formula (A1), the plurality of structural units represented by the formula (A1) are identical or different from each other;
         when the resin includes a plurality of structural units represented by the formula (C1), the plurality of structural units represented by the formula (C1) are identical or different from each other; and
         when the resin includes a plurality of structural units represented by the formula (D1), the plurality of structural units represented by the formula (D1) are identical or different from each other.
[Configuration 27] The resin according to Configuration 26, in which the resin is a resin including the structural units represented by the formulae (A1) and (B1).
[Configuration 28] The resin according to Configuration 26, in which the resin is a resin including the structural units represented by the formulae (A1), (B1), and (D1).
[Configuration 29] The resin according to any one of Configurations 26 to 28, in which a ratio a:d of a mole fraction a of the structural unit represented by the formula (A1) to a mole fraction d of the structural unit represented by the formula (D1) in the resin is in a range from 5:95 to 100:0.
[Configuration 30] The resin according to Configuration 28 or 29, in which a ratio a:d of a mole fraction a of the structural unit represented by the formula (A1) to a mole fraction d of the structural unit represented by the formula (D1) in the resin is in a range from 10:90 to 50:50.
[Configuration 31] The resin according to any one of Configurations 26 to 30, in which the structural unit represented by the formula (A1) is represented by a formula (A10) below. 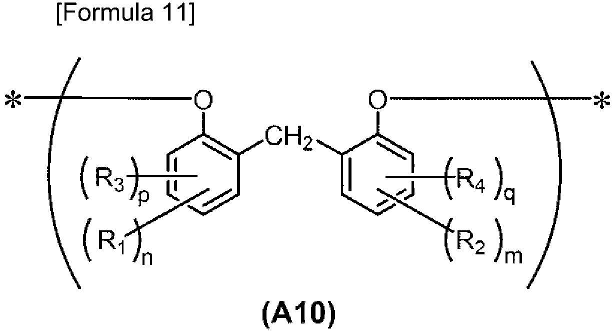 **In** the formula (A10), R₁, R₂, R₃, R₄, n, m, p, q, and * respectively represent the same as R₁, R₂, R₃, R₄, n, m, p, q, and * in the formula (A1).
[Configuration 32] The resin according to any one of Configurations 26 to 31, in which n and m are each 1.
[Configuration 33] The resin according to any one of Configurations 26 to 32, in which the structural unit represented by the formula (A1) is represented by a formula (A11) below. 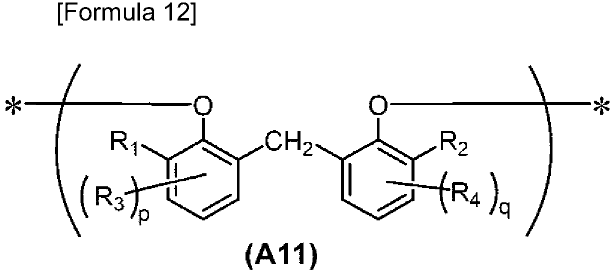 In the formula (A11), R₁, R₂, R₃, R₄, p, q, and * respectively represent the same as R₁, R₂, R₃, R₄, p, q, and * in the formula (A1).
[Configuration 34] The resin according to any one of Configurations 26 to 33, in which p and q are each 1.
[Configuration 35] The resin according to any one of Configurations 26 to 34, in which the structural unit represented by the formula (A1) is represented by a formula (A12) below. 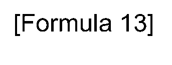 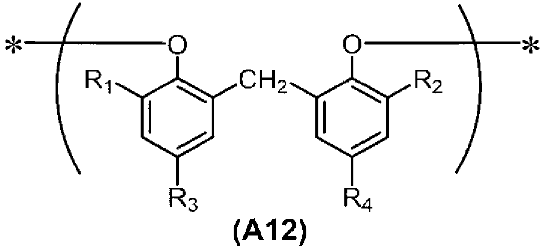 In the formula (A12), R₁, R₂, R₃, R₄, and * respectively represent the same as R₁, R₂, R₃, R₄, and * in the formula (A1).
[Configuration 36] The resin according to any one of Configurations 26 to 35, in which the structural unit represented by the formula (D1) is represented by a formula (D2) below. 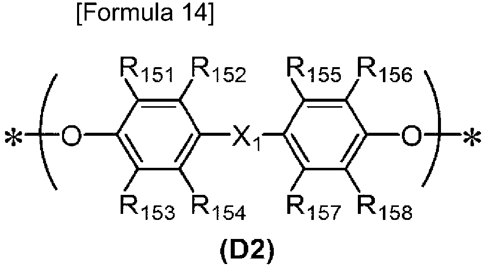 In the formula (D2):
   R₁₅₁ to R₁₅₈ are each independently selected from the group consisting of a hydrogen atom, a halogen atom, a substituted or unsubstituted alkyl group having 1 to 18 carbon atoms, a substituted or unsubstituted alkoxy group having 1 to 18 carbon atoms, a substituted or unsubstituted cycloalkyl group having 6 to 20 ring carbon atoms, a substituted or unsubstituted cycloalkoxy group having 6 to 20 ring carbon atoms, a substituted or unsubstituted alkenyl group having 2 to 10 carbon atoms, a substituted or unsubstituted aryl group having 6 to 14 ring carbon atoms, a substituted or unsubstituted aryloxy group having 6 to 14 ring carbon atoms, a substituted or unsubstituted aralkyl group having 7 to 20 carbon atoms, a substituted or unsubstituted aralkyloxy group having 7 to 20 carbon atoms, a nitro group, an aldehyde group, a cyano group, and a carboxy group;
   X₁ is (i) a single bond; (ii) a group selected from the group consisting of a substituted or unsubstituted alkylene group having 1 to 28 carbon atoms, a substituted or unsubstituted alkylidene group having 2 to 28 carbon atoms, a substituted or unsubstituted cycloalkylene group having 5 to 15 ring carbon atoms, a substituted or unsubstituted cycloalkylidene group having 3 to 26 ring carbon atoms, a substituted or unsubstituted arylene group having 6 to 20 ring carbon atoms, -S-, - SO-, -SO₂-, -O-, and -CO-; or (iii) a divalent group formed by linking two or more groups selected from the group described in (ii) above; and
   each * represents a bond.
[Configuration 37] The resin according to Configuration 36, in which X₁ is a substituted or unsubstituted cycloalkylidene group having 5 to 15 ring carbon atoms.
[Configuration 38] The resin according to Configuration 36 or 37, in which R₁₅₁ to R₁₅₈ are each independently a hydrogen atom, a substituted or unsubstituted alkyl group having 1 to 18 carbon atoms, or a substituted or unsubstituted cycloalkyl group having 6 to 20 ring carbon atoms.
[Configuration 39] The resin according to any one of Configurations 26 to 35, in which the structural unit represented by the formula (D1) is represented by a formula (D3) below. 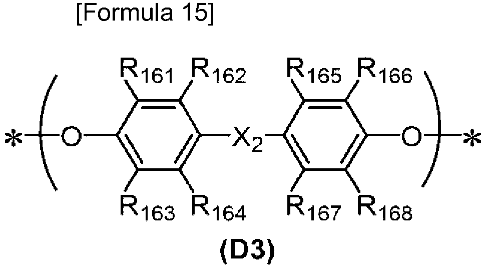 In the formula (D3):
   X₂ is (i) a single bond, or (ii) a substituted or unsubstituted divalent organic group having 7 to 12 carbon atoms;
   R₁₆₁ to R₁₆₈ are each independently a hydrogen atom, or a substituted or unsubstituted organic group having 1 to 10 carbon atoms; and
   each * represents a bond.
[Configuration 40] The resin according to any one of Configurations 26 to 39, in which a reduced viscosity of the resin is 0.80 dL/g or less, and the reduced viscosity of the resin is a reduced viscosity at 20 degrees C of a solution having a concentration of 0.5 g/dL, in which methylene chloride is used as a solvent and the resin is used as a solute.
[Configuration 41] The resin according to any one of Configurations 26 to 40, in which the resin includes a repeating unit represented by a formula (PC-AB1) below in which the structural unit represented by the formula (A1) is bonded to the structural unit represented by the formula (B1), and consecutive repeating units each represented by the formula (PC-AB1) are absent in the resin. 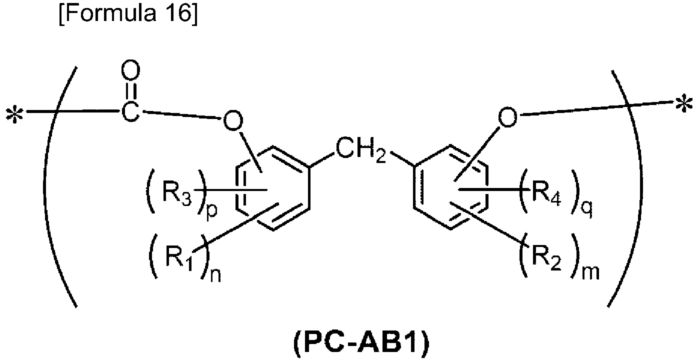 In the formula (PC-AB1), R₁, R₂, R₃, R₄, m, n, p, and q respectively represent the same as R₁, R₂, R₃, R₄, m, n, p, and q in the formula (A1), and each * represents a bond.
[Configuration 42] The resin according to any one of Configurations 26 to 38, in which the resin is a polycarbonate resin.
[Configuration 43] The resin according to any one of Configurations 26 to 42, in which a dielectric constant Dk of the resin is 2.70 or less.
[Configuration 44] The resin according to any one of Configurations 26 to 43, in which a dissipation factor Df of the resin is 0.00300 or less.
[Configuration 45] The resin according to any one of Configurations 26 to 44, in which a viscosity-average molecular weight Mv of the resin is in a range from 1,000 to 30,000.
[Configuration 46] A coating liquid composition, containing: the resin according to any one of Configurations 26 to 45; and a non-halogenated solvent.
[Configuration 47] A film containing the resin according to any one of Configurations 26 to 45.
[Configuration 48] A sheet containing the resin according to any one of Configurations 26 to 45.
[Configuration 49] An electronic substrate containing the resin according to any one of Configurations 26 to 45.
[Configuration 50] A resin production method for producing the resin according to any one of Configurations 26 to 45, including: polymerizing the resin using a composition represented by a formula (MA1) below, in which the polymerizing is performed without causing the compound represented by the formula (MA1) to coexist with phosgene. 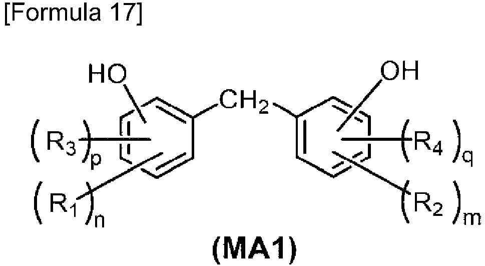 In the formula (MA1), R₁, R₂, R₃, R₄, m, n, p, and q respectively represent the same as R₁, R₂, R₃, R₄, m, n, p, and q in the formula (A1).

According to one aspect of the invention, a resin and an electronic substrate material each having dielectric properties enabling use as an electronic substrate material and exhibiting excellent solubility in non-halogenated solvents can be provided. According to another aspect of the invention, a coating liquid composition, a film, a sheet, and an electronic substrate each containing the resin or the electronic substrate material, as well as a method for producing the resin, can be provided.

### DESCRIPTION OF EMBODIMENT(S)

### First Exemplary Embodiment

### Resin

A resin according to the exemplary embodiment is at least one resin selected from the group consisting of polycarbonate, polyester, and polyester polycarbonate. The resin according to the exemplary embodiment corresponds to a first resin in an electronic substrate material described below.

The resin according to the exemplary embodiment includes a structural unit represented by a formula (A1) below and at least one structural unit selected from the group consisting of structural units represented by formulae (B1), (C1), and (D1) below.

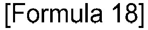

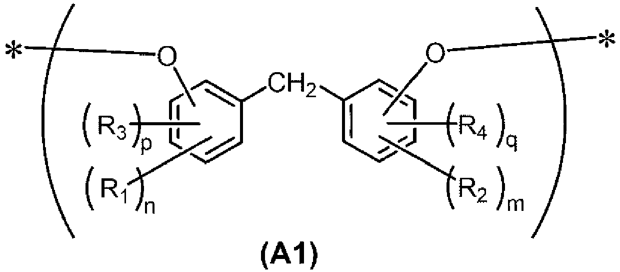

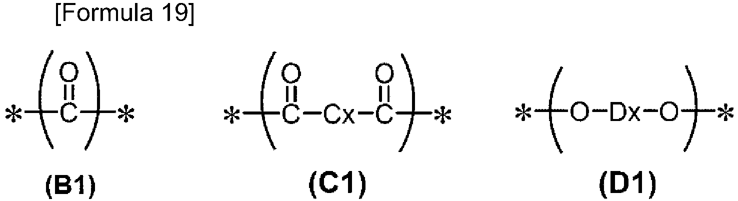

In the formula (A1):
R₁ and R₂ are each independently a substituted or unsubstituted cycloalkyl group having 3 to 20 ring carbon atoms;
n represents 1, 2, 3, or 4, and a plurality of R₁ are identical or different from each other;
m represents 1, 2, 3, or 4, and a plurality of R₂ are identical or different from each other;
R₃ and R₄ are each independently a substituted or unsubstituted alkyl group having 1 to 20 carbon atoms, a substituted or unsubstituted alkenyl group having 2 to 10 carbon atoms, a substituted or unsubstituted alkynyl group having 2 to 10 carbon atoms, a substituted or unsubstituted aryl group having 6 to 14 ring carbon atoms, a substituted or unsubstituted alkoxy group having 1 to 20 carbon atoms, a substituted or unsubstituted cycloalkoxy group having 3 to 20 ring carbon atoms, a substituted or unsubstituted aryloxy group having 6 to 14 ring carbon atoms, a substituted or unsubstituted aralkyl group having 7 to 20 carbon atoms, a substituted or unsubstituted aralkyloxy group having 7 to 20 carbon atoms, a substituted or unsubstituted heteroaryl group having 5 to 14 ring atoms, a halogen atom, a nitro group, an aldehyde group, a cyano group, or a carboxy group;
p represents 0, 1, 2, or 3, and a plurality of R₃ are identical or different from each other;
q represents 0, 1, 2, or 3, and a plurality of R₄ are identical or different from each other;
a sum of n and p is 1, 2, 3, or 4;
a sum of m and q is 1, 2, 3, or 4; and
the structural unit represented by the formula (B1) is different from a carbonyl group in the formula (C1);
in the formula (C1):
   Cx is a divalent group including at least one group selected from the group consisting of a substituted or unsubstituted divalent aromatic hydrocarbon group, a substituted or unsubstituted divalent cyclic aliphatic hydrocarbon group, and a substituted or unsubstituted divalent acyclic aliphatic hydrocarbon group;
   in the formula (D1):
      Dx is a divalent group including at least one group selected from the group consisting of a substituted or unsubstituted divalent aromatic hydrocarbon group, a substituted or unsubstituted divalent cyclic aliphatic hydrocarbon group, and a substituted or unsubstituted divalent acyclic aliphatic hydrocarbon group;
      the structural unit represented by the formula (A1) and the structural unit represented by the formula (D1) are different from each other;
      substituents for a "substituted or unsubstituted" group are bonded to each other to form a monocyclic ring, bonded to each other to form a fused ring, or not bonded to each other;
      each * in the formulae (A1), (B1), (C1) and (D1) represents a bond;
      when the resin includes a plurality of structural units represented by the formula (A1), the plurality of structural units represented by the formula (A1) are identical or different from each other;
      when the resin includes a plurality of structural units represented by the formula (C1), the plurality of structural units represented by the formula (C1) are identical or different from each other; and
      when the resin includes a plurality of structural units represented by the formula (D1), the plurality of structural units represented by the formula (D1) are identical or different from each other.

Since the resin according to the exemplary embodiment includes the structural unit represented by the formula (A1), the resin has dielectric properties enabling use as an electronic substrate material and exhibits excellent solubility in non-halogenated solvents.

In the resin according to the exemplary embodiment, the structural units represented by the formula (A1) are not continuously bonded to each other, the structural units represented by the formula (B1) are not continuously bonded to each other, the structural units represented by the formula (C1) are not continuously bonded to each other, and the structural units represented by the formula (D1) are not continuously bonded to each other.

One embodiment of the resin according to the exemplary embodiment is a resin including the structural units represented by the formulae (A1) and (B1).

One embodiment of the resin according to the exemplary embodiment is a resin (polycarbonate resin or polyester polycarbonate resin) including a repeating unit represented by a formula (PC-AB1) below in which the structural unit represented by the formula (A1) is bonded to the structural unit represented by the formula (B1).

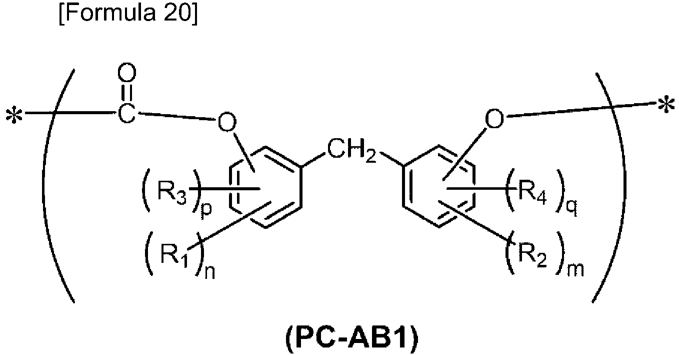

In the formula (PC-AB1), R₁, R₂, R₃, R₄, m, n, p, and q respectively represent the same as R₁, R₂, R₃, R₄, m, n, p, and q in the formula (A1), and each * represents a bond.

In one embodiment of the resin according to the exemplary embodiment, consecutive repeating units each represented by the formula (PC-AB1) may be absent in the resin.

In one embodiment of the resin according to the exemplary embodiment, the absence of consecutive repeating units each represented by the formula (PC-AB1) means that the resin includes no structure in which the repeating units represented by the formula (PC-AB1) are directly bonded to each other as represented by a formula (PC-AB12) below.

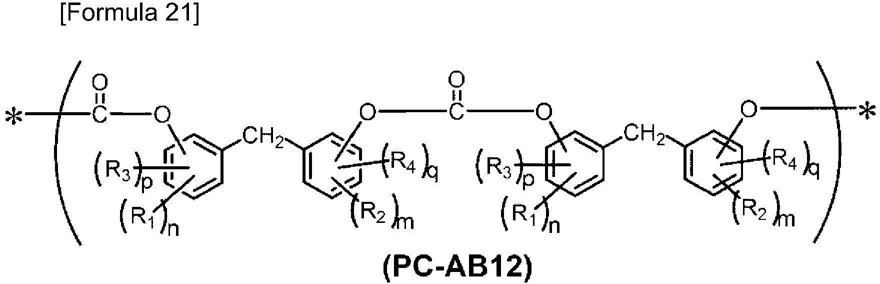

In the formula (PC-AB12), R₁, R₂, R₃, R₄, m, n, p, and q respectively represent the same as R₁, R₂, R₃, R₄, m, n, p, and q in the formula (A1), and each * represents a bond.

One embodiment of the resin according to the exemplary embodiment may be a resin (polycarbonate resin) including, as the repeating unit, only the repeating unit represented by the formula (PC-AB1). That is, in one embodiment of the resin according to the exemplary embodiment, consecutive repeating units each represented by the formula (PC-AB1) may be present in the resin.

One embodiment of the resin according to the exemplary embodiment is a resin including the structural units represented by the formulae (A1) and (C1).

One embodiment of the resin according to the exemplary embodiment is a resin (polyester resin or polyester polycarbonate resin) including a repeating unit represented by a formula (PE-AC1) below in which the structural unit represented by the formula (A1) is bonded to the structural unit represented by the formula (C1).

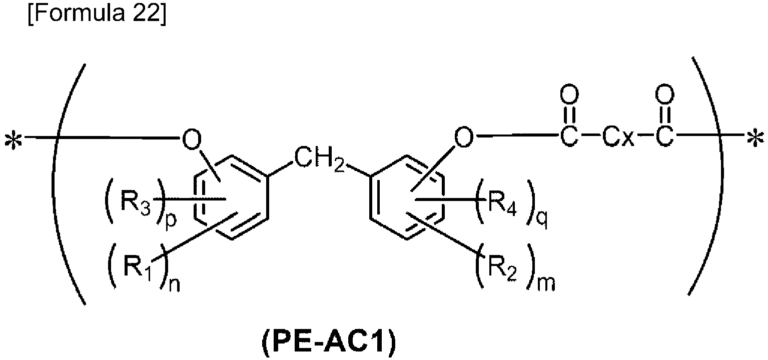

In the formula (PE-AC1), R₁, R₂, R₃, R₄, m, n, p, and q respectively represent the same as R₁, R₂, R₃, R₄, m, n, p, and q in the formula (A1) or (C1), Cx represents the same as Cx in the formula (C1), and each * represents a bond.

In one embodiment of the resin according to the exemplary embodiment, the structural unit represented by the formula (A1) is represented by a formula (A10) below.

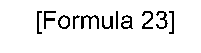

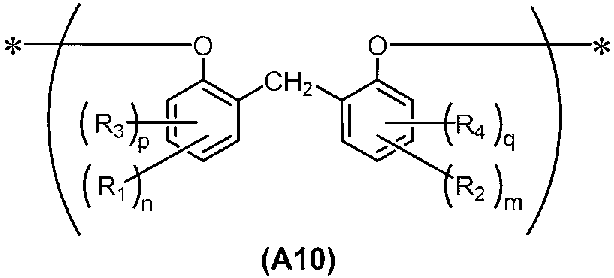

In the formula (A10), R₁, R₂, R₃, R₄, n, m, p, q, and * respectively represent the same as R₁, R₂, R₃, R₄, n, m, p, q, and * in the formula (A1).

One embodiment of the resin according to the exemplary embodiment is a resin (polycarbonate resin or polyester polycarbonate resin) including a repeating unit represented by a formula (PC-AB101) below in which the structural unit represented by the formula (A10) is bonded to the structural unit represented by the formula (B1).

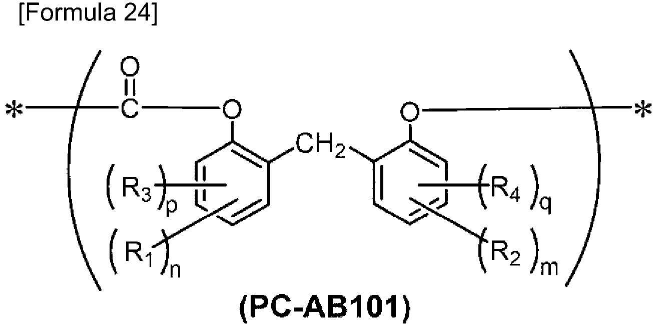

In the formula (PC-AB101), R₁, R₂, R₃, R₄, m, n, p, and q respectively represent the same as R₁, R₂, R₃, R₄, m, n, p, and q in the formula (A1), and each * represents a bond.

One embodiment of the resin according to the exemplary embodiment is a resin (polyester resin or polyester polycarbonate resin) including a repeating unit represented by a formula (PE-AC101) below in which the structural unit represented by the formula (A10) is bonded to the structural unit represented by the formula (C1).

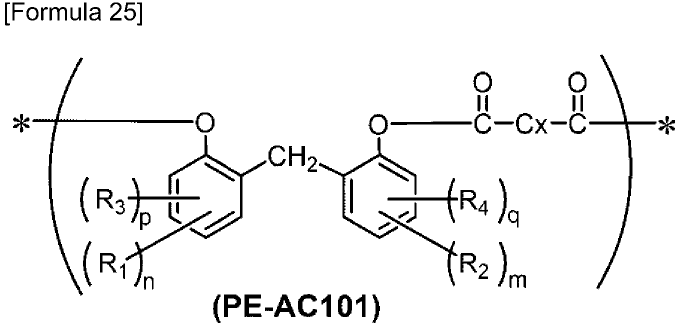

In the formula (PE-AC101), R₁, R₂, R₃, R₄, m, n, p, and q respectively represent the same as R₁, R₂, R₃, R₄, m, n, p, and q in the formula (A1), Cx represents the same as Cx in the formula (C1), and each * represents a bond.

In one embodiment of the resin according to the exemplary embodiment, the structural unit represented by the formula (A1) is represented by a formula (A20) below.

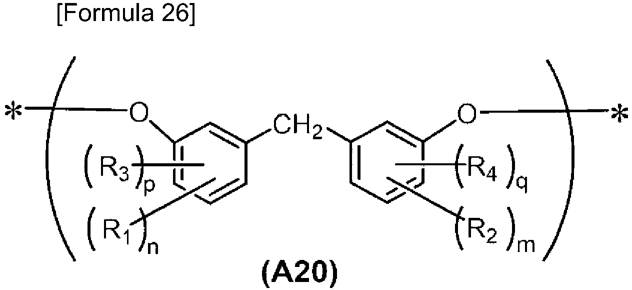

In the formula (A20), R₁, R₂, R₃, R₄, n, m, p, q, and * respectively represent the same as R₁, R₂, R₃, R₄, n, m, p, q, and * in the formula (A1).

In one embodiment of the resin according to the exemplary embodiment, the structural unit represented by the formula (A1) is represented by a formula (A30) below.

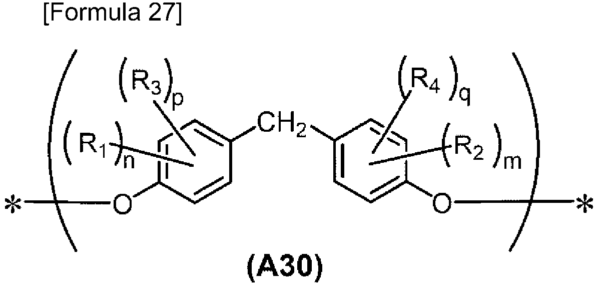

In the formula (A30), R₁, R₂, R₃, R₄, n, m, p, q, and * respectively represent the same as R₁, R₂, R₃, R₄, n, m, p, q, and * in the formula (A1).

In one embodiment of the resin according to the exemplary embodiment, n and m are each 1.

In one embodiment of the resin according to the exemplary embodiment, the structural unit represented by the formula (A1) is represented by a formula (A11) below.

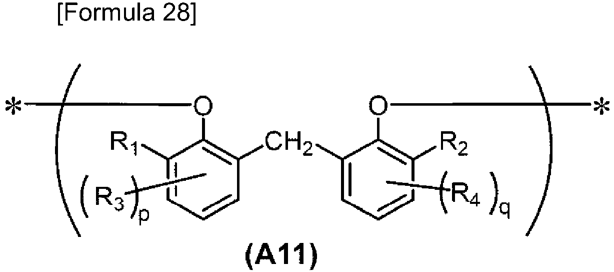

In the formula (A11), R₁, R₂, R₃, R₄, p, q, and * respectively represent the same as R₁, R₂, R₃, R₄, p, q, and * in the formula (A1).

One embodiment of the resin according to the exemplary embodiment is a resin (polycarbonate resin or polyester polycarbonate resin) including a repeating unit represented by a formula (PC-AB111) below in which the structural unit represented by the formula (A11) is bonded to the structural unit represented by the formula (B1).

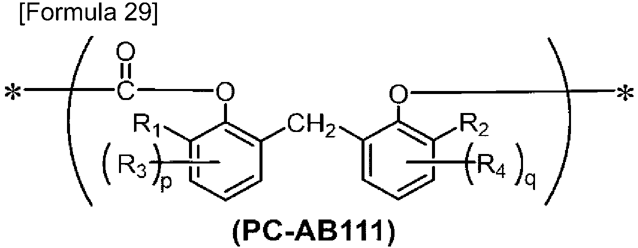

In the formula (PC-AB111), R₁, R₂, R₃, R₄, p, and q respectively represent the same as R₁, R₂, R₃, R₄, p, and q in the formula (A1), and each * represents a bond.

One embodiment of the resin according to the exemplary embodiment is a resin (polyester resin or polyester polycarbonate resin) including a repeating unit represented by a formula (PE-AC111) below in which the structural unit represented by the formula (A11) is bonded to the structural unit represented by the formula (C1).

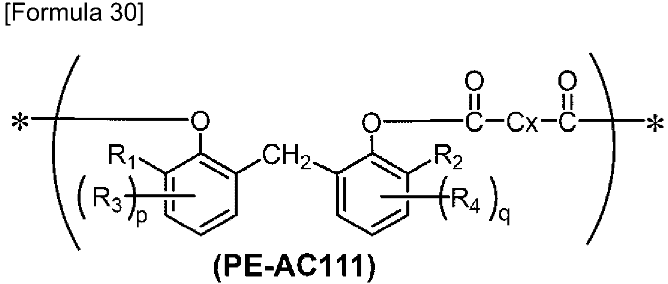

In the formula (PE-AC111), R₁, R₂, R₃, R₄, p, and q respectively represent the same as R₁, R₂, R₃, R₄, p, and q in the formula (A1), Cx represents the same as Cx in the formula (C1), and each * represents a bond.

In one embodiment of the resin according to the exemplary embodiment, p and q are each 1.

In one embodiment of the resin according to the exemplary embodiment, the structural unit represented by the formula (A1) is represented by a formula (A12) below.

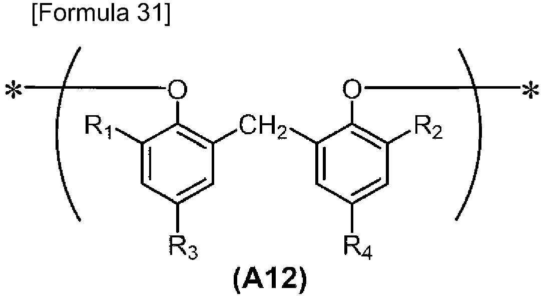

In the formula (A12), R₁, R₂, R₃, R₄, and * respectively represent the same as R₁, R₂, R₃, R₄, and * in the formula (A1).

One embodiment of the resin according to the exemplary embodiment is a resin (polycarbonate resin or polyester polycarbonate resin) including a repeating unit represented by a formula (PC-AB121) below in which the structural unit represented by the formula (A12) is bonded to the structural unit represented by the formula (B1).

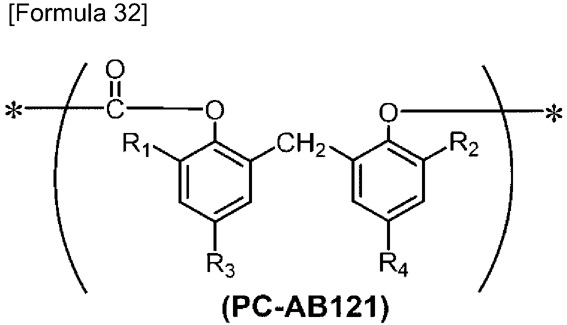

In the formula (PC-AB121), R₁, R₂, R₃, and R₄ respectively represent the same as R₁, R₂, R₃, and R₄ in the formula (A1), and each * represents a bond.

One embodiment of the resin according to the exemplary embodiment is a resin (polyester resin or polyester polycarbonate resin) including a repeating unit represented by a formula (PE-AC121) below in which the structural unit represented by the formula (A12) is bonded to the structural unit represented by the formula (C1).

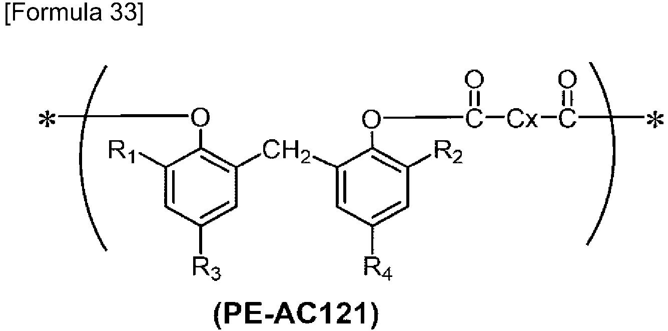

In the formula (PE-AC121), R₁, R₂, R₃, and R₄ respectively represent the same as R₁, R₂, R₃, and R₄ in the formula (A1), Cx represents the same as Cx in the formula (C1), and each * represents a bond.

### Copolymer

The resin according to the exemplary embodiment may be a copolymer.

A copolymer according to the exemplary embodiment is at least one copolymer selected from the group consisting of a polycarbonate copolymer, a polyester copolymer, and a polyester polycarbonate copolymer.

One embodiment of the copolymer according to the exemplary embodiment includes the structural unit represented by the formula (A1) and at least one structural unit selected from the group consisting of the structural units represented by the formulae (B1), (C1), and (D1).

One embodiment of the copolymer according to the exemplary embodiment includes the structural unit represented by the formula (A1) and the structural unit represented by the formula (B1), as well as at least one structural unit selected from the group consisting of the structural units represented by the formulae (C1) and (D1).

One embodiment of the copolymer according to the exemplary embodiment includes the structural unit represented by the formula (A1) and the structural unit represented by the formula (C1), as well as at least one structural unit selected from the group consisting of the structural units represented by the formulae (B1) and (C1).

When the copolymer according to the exemplary embodiment includes a plurality of structural units represented by the formula (A1), the plurality of structural units represented by the formula (A1) are identical or different from each other.

When the copolymer according to the exemplary embodiment includes a plurality of structural units represented by the formula (C1), the plurality of structural units represented by the formula (C1) are identical or different from each other.

When the copolymer according to the exemplary embodiment includes a plurality of structural units represented by the formula (D1), the plurality of structural units represented by the formula (D1) are identical or different from each other.

In the copolymer according to the exemplary embodiment, the respective repeating units are not necessarily consecutive. One embodiment of the copolymer according to the exemplary embodiment is a block copolymer, an alternating copolymer, or a random copolymer.

The resin and the copolymer according to one embodiment of the exemplary embodiment are a resin and a copolymer, each of which includes the structural units represented by the formulae (A1), (B1), and (D1).

In one embodiment of the copolymer according to the exemplary embodiment, the structural unit represented by the formula (A1) is the structural unit represented by the formula (A10), (A11), (A12), (A20), or (A30).

In one embodiment, the resin and the copolymer according to the exemplary embodiment are a resin (polycarbonate resin or polyester polycarbonate resin) and a copolymer, each of which includes the repeating unit represented by the formula (PC-AB1), (PC-AB101), (PC-AB111), or (PC-AB121) and a repeating unit represented by a formula (PC-DB1) below.

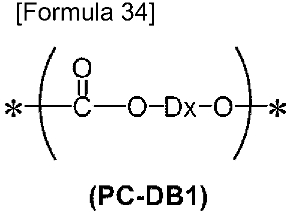

In the formula (PC-DB1), Dx represents the same as Dx in the formula (D1), and each * represents a bond.

One embodiment of the resin and the copolymer according to the exemplary embodiment is a resin (polycarbonate resin) including, as the repeating units, only the repeating unit represented by the formula (PC-AB1) and the repeating unit represented by the formula (PC-DB1).

In one embodiment of the exemplary embodiment, with respect to the repeating unit in the resin according to the exemplary embodiment or the copolymer according to the exemplary embodiment, a total mole fraction a + d of a mole fraction a of the repeating unit represented by the formula (PC-AB1) and a mole fraction d of the repeating unit represented by the formula (PC-DB1) is 50 mol% or more, 70 mol% or more, 80 mol% or more, 90 mol% or more, or 99 mol% or more, and the total mole fraction a + d is 100 mol% or less.

In one embodiment of the resin and the copolymer according to the exemplary embodiment, the repeating unit represented by the formula (PC-AB1) is represented by the formula (PC-AB101), (PC-AB111), or (PC-AB121).

In one embodiment of the resin and the copolymer according to the exemplary embodiment, a ratio a:d of the mole fraction a of the structural unit represented by the formula (A1) to the mole fraction d of the structural unit represented by the formula (D1) in the resin according to the exemplary embodiment or the copolymer according to the exemplary embodiment is in a range from 5:95 to 100:0.

In one embodiment of the resin and the copolymer according to the exemplary embodiment, the ratio a:d of the mole fraction a of the structural unit represented by the formula (A1) to the mole fraction d of the structural unit represented by the formula (D1) in the resin according to the exemplary embodiment or the copolymer according to the exemplary embodiment is in a range from 10:90 to 50:50.

In one embodiment of the resin and the copolymer according to the exemplary embodiment, the ratio a:d of the mole fraction a of the structural unit represented by the formula (A1) to the mole fraction d of the structural unit represented by the formula (D1) in the resin according to the exemplary embodiment or the copolymer according to the exemplary embodiment is in a range from 28:72 to 50:50, a range from 30:70 to 50:50, or a range from 30:70 to 40:55.

The mole fraction of each structural unit or repeating unit in the resin and the copolymer according to the exemplary embodiment is calculated by nuclear magnetic resonance (NMR) measurement. Specifically, ¹H-NMR measurement is performed, and each mole fraction is calculated from a peak integration value derived from the corresponding structural unit or repeating unit.

In one embodiment of the resin and the copolymer according to the exemplary embodiment, Dx is a group represented by a formula (D10) below.

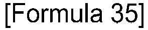

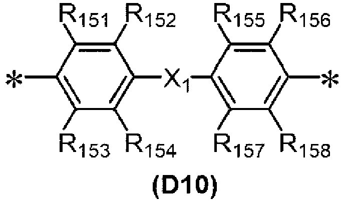

In the formula (D10), R₁₅₁ to R₁₅₈ and X₁ respectively represent the same as R₁₅₁ to R₁₅₈ and X₁ in a formula (D2) below, and each * represents a bond.

In one embodiment of the resin and the copolymer according to the exemplary embodiment, the structural unit represented by the formula (D1) is represented by the formula (D2) below.

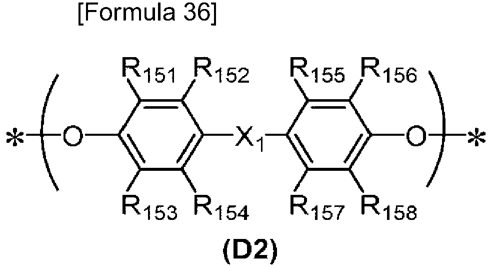

In the formula (D2):
R₁₅₁ to R₁₅₈ are each independently selected from the group consisting of a hydrogen atom, a halogen atom, a substituted or unsubstituted alkyl group having 1 to 18 carbon atoms, a substituted or unsubstituted alkoxy group having 1 to 18 carbon atoms, a substituted or unsubstituted cycloalkyl group having 6 to 20 ring carbon atoms, a substituted or unsubstituted cycloalkoxy group having 6 to 20 ring carbon atoms, a substituted or unsubstituted alkenyl group having 2 to 10 carbon atoms, a substituted or unsubstituted aryl group having 6 to 14 ring carbon atoms, a substituted or unsubstituted aryloxy group having 6 to 14 ring carbon atoms, a substituted or unsubstituted aralkyl group having 7 to 20 carbon atoms, a substituted or unsubstituted aralkyloxy group having 7 to 20 carbon atoms, a nitro group, an aldehyde group, a cyano group, and a carboxy group;
X₁ is (i) a single bond; (ii) a group selected from the group consisting of a substituted or unsubstituted alkylene group having 1 to 28 carbon atoms, a substituted or unsubstituted alkylidene group having 2 to 28 carbon atoms, a substituted or unsubstituted cycloalkylene group having 5 to 15 ring carbon atoms, a substituted or unsubstituted cycloalkylidene group having 3 to 26 ring carbon atoms, a substituted or unsubstituted arylene group having 6 to 20 ring carbon atoms, -S-, - SO-, -SO₂-, -O-, and -CO-; or (iii) a divalent group formed by linking two or more groups selected from the group described in (ii) above; and
each * represents a bond.

In one embodiment of the resin and the copolymer according to the exemplary embodiment, the structural unit represented by the formula (B1) is different from a carbonyl group in the structural units represented by the formulae (A1), (C1), and (D1).

In one embodiment of the resin and the copolymer according to the exemplary embodiment, the repeating unit represented by the formula (PC-DB1) is represented by a formula (PC-DB2) below.

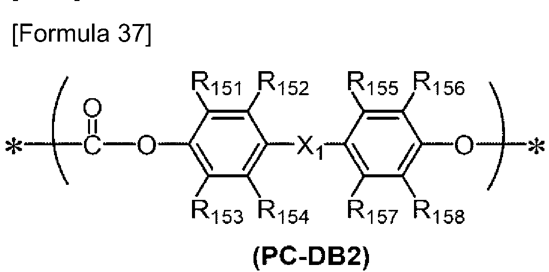

In the formula (PC-DB2), R₁₅₁ to R₁₅₈ and X₁ respectively represent the same as R₁₅₁ to R₁₅₈ and X₁ in the formula (D2), and each * represents a bond.

In one embodiment of the resin and the copolymer according to the exemplary embodiment, X₁ is a substituted or unsubstituted cycloalkylidene group having 5 to 15 ring carbon atoms.

In one embodiment of the resin and the copolymer according to the exemplary embodiment, Dx is a group represented by a formula (D11) below.

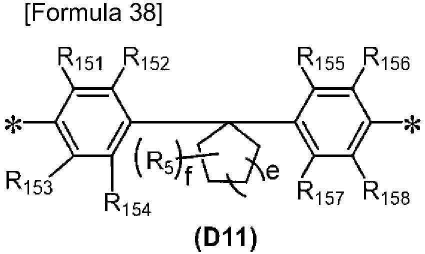

In the formula (D11):
R₁₅₁ to R₁₅₈ respectively represent the same as R₁₅₁ to R₁₅₈ in the formula (D2);
e is 1, 2, 3, 4, 5, 6, 7, or 8;
f is 2e + 6;
a plurality of R₅ are each independently selected from the group consisting of a hydrogen atom, a halogen atom, a substituted or unsubstituted alkyl group having 1 to 18 carbon atoms, a substituted or unsubstituted alkoxy group having 1 to 18 carbon atoms, a substituted or unsubstituted cycloalkyl group having 6 to 20 ring carbon atoms, a substituted or unsubstituted cycloalkoxy group having 6 to 20 ring carbon atoms, a substituted or unsubstituted alkenyl group having 2 to 10 carbon atoms, a substituted or unsubstituted aryl group having 6 to 14 ring carbon atoms, a substituted or unsubstituted aryloxy group having 6 to 14 ring carbon atoms, a substituted or unsubstituted aralkyl group having 7 to 20 carbon atoms, a substituted or unsubstituted aralkyloxy group having 7 to 20 carbon atoms, a nitro group, an aldehyde group, a cyano group, and a carboxy group; and
each * represents a bond.

In one embodiment of the resin and the copolymer according to the exemplary embodiment: when e in the group represented by the formula (D11) is 1, the group represented by the formula (D11) is represented by a formula (D111) below; when e is 2, the group represented by the formula (D11) is represented by a formula (D112) below; when e is 3, the group represented by the formula (D11) is represented by a formula (D113) below; and when e is 8, the group represented by the formula (D11) is represented by a formula (D118) below.

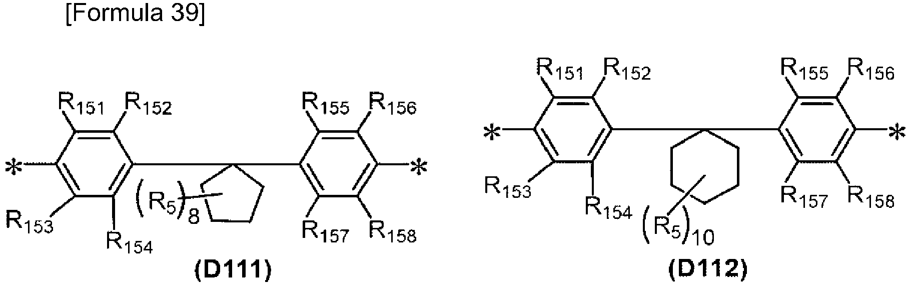

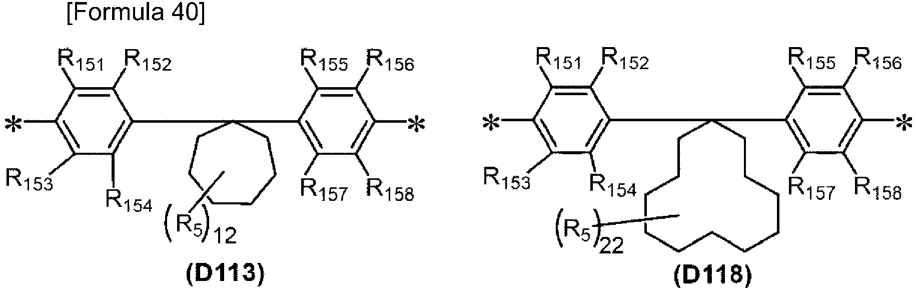

In the formulae (D111), (D112), (D113), and (D118), R₁₅₁ to R₁₅₈ respectively represent the same as R₁₅₁ to R₁₅₈ in the formula (D2), a plurality of R₅ each independently represent the same as R₅ in the formula (D11), and each * represents a bond.

In one embodiment of the resin and the copolymer according to the exemplary embodiment, the repeating unit represented by the formula (PC-DB1) is represented by a formula (PC-DB11) below.

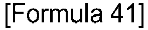

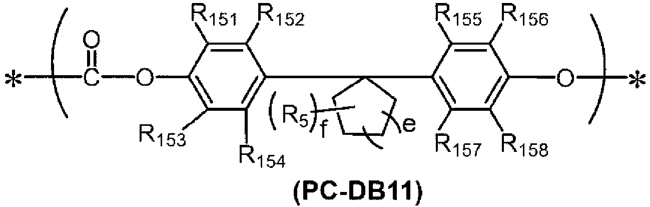

In the formula (PC-DB11), R₁₅₁ to R₁₅₈ respectively represent the same as R₁₅₁ to R₁₅₈ in the formula (D2), R₅, e, and f respectively represent the same as R₅, e, and f in the formula (D11), and each * represents a bond.

In one embodiment of the resin and the copolymer according to the exemplary embodiment, the repeating unit represented by the formula (PC-DB1) is at least one repeating unit selected from the group consisting of repeating units represented by formulae (PC-DB111), (PC-DB112), (PC-DB113), and (PC-DB118) below.

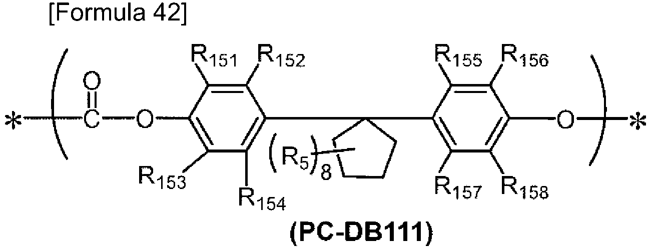

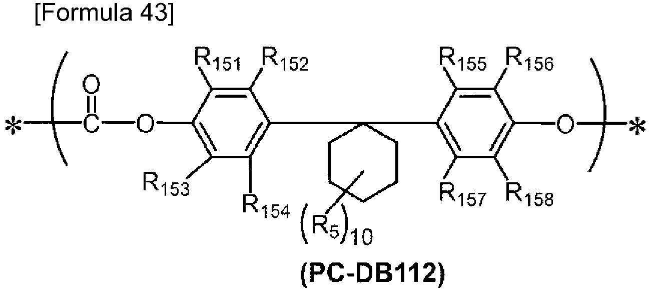

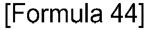

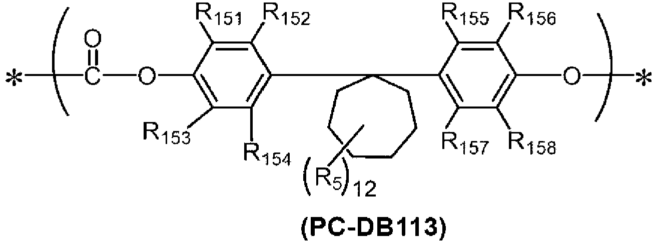

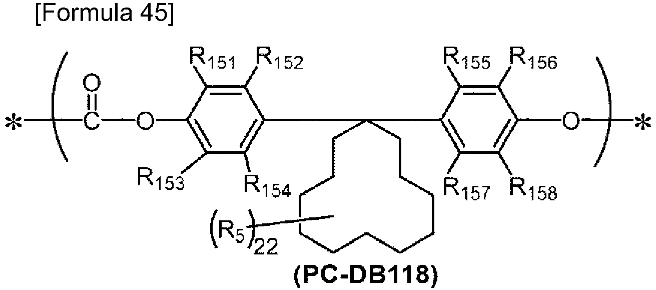

In the formulae (PC-DB111), (PC-DB112), (PC-DB113), and (PC-DB118), R₁₅₁ to R₁₅₈ respectively represent the same as R₁₅₁ to R₁₅₈ in the formula (D2), each R₅ represents the same as R₅ in the formula (D11), and each * represents a bond.

In one embodiment of the resin and the copolymer according the exemplary embodiment, R₁₅₁ to R₁₅₈ are each independently a hydrogen atom, a substituted or unsubstituted alkyl group having 1 to 18 carbon atoms, or a substituted or unsubstituted cycloalkyl group having 6 to 20 ring carbon atoms.

In one embodiment of the resin and the copolymer according to the exemplary embodiment, a plurality of R₅ are each independently a hydrogen atom, or a substituted or unsubstituted alkyl group having 1 to 18 carbon atoms.

In one embodiment of the resin and the copolymer according to the exemplary embodiment, the structural unit represented by the formula (D1) is represented by a formula (D3) below.

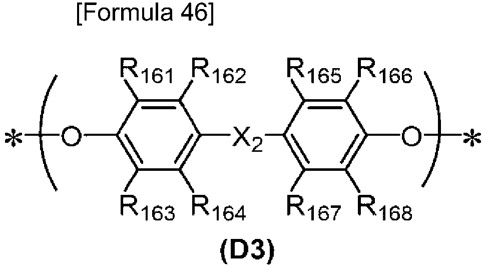

In the formula (D3):
X₂ is (i) a single bond, or (ii) a substituted or unsubstituted divalent organic group having 7 to 12 carbon atoms;
R₁₆₁ to R₁₆₈ are each independently a hydrogen atom, or a substituted or unsubstituted organic group having 1 to 10 carbon atoms; and
each * represents a bond.

In one embodiment of the resin and the copolymer according to the exemplary embodiment, examples of the divalent organic group having 7 to 12 carbon atoms include an octylidene group, a cyclooctylidene group, a cyclododecylidene group, and a 3,3,5-trimethylcyclohexylidene group.

In one embodiment of the resin and the copolymer according to the exemplary embodiment, examples of the organic group having 1 to 10 carbon atoms include a methyl group, a butyl group, a propyl group, an isopropyl group, a cyclohexyl group, and a phenyl group.

In one embodiment of the resin and the copolymer according to the exemplary embodiment, the repeating unit represented by the formula (PC-DB1) is represented by a formula (PC-DB3) below.

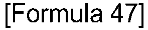

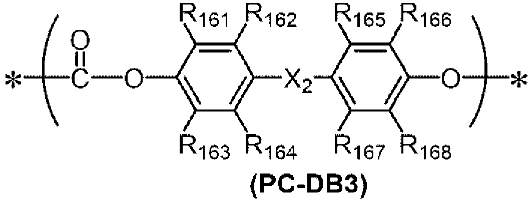

In the formula (PC-DB3), R₁₆₁ to R₁₆₈ and X₂ respectively represent the same as R₁₆₁ to R₁₆₈ and X₂ in the formula (D3), and each * represents a bond.

In one embodiment, the resin and the copolymer according to the exemplary embodiment are a resin (polycarbonate resin or polyester polycarbonate resin) and a copolymer, each of which includes no repeating unit represented by a formula (PC-DB101) below.

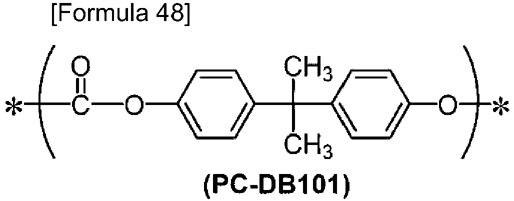

In one embodiment, the resin and the copolymer according to the exemplary embodiment are a resin (polycarbonate resin or polyester polycarbonate resin) and a copolymer, each of which includes no repeating unit represented by a formula (PC-DB102) below.

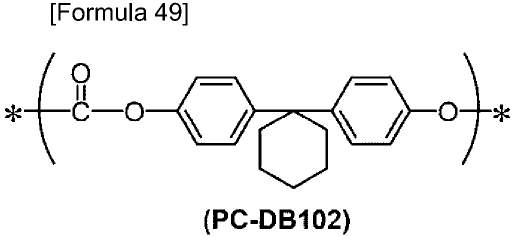

In the formulae (PC-DB101) and (PC-DB102), each * represents a bond.

In one embodiment, the resin and the copolymer according to the exemplary embodiment are a resin (polyester resin or polyester polycarbonate resin) and a copolymer, each of which includes a repeating unit represented by a formula (PE-DC1) below.

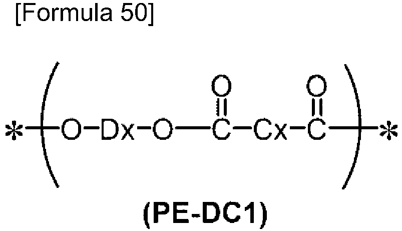

In the formula (PE-DC1), Dx represents the same as Dx in the formula (D1), Cx represents the same as Cx in the formula (C1), and each * represents a bond.

In one embodiment of the resin and the copolymer according to the exemplary embodiment, Cx is a group including at least one selected from the group consisting of groups represented by formulae (C10), (C11), (C12), and (C13) below.

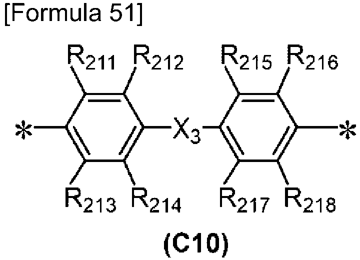

In the formula (C10):
R₂₁₁ to R₂₁₈ are each independently selected from the group consisting of a hydrogen atom, a halogen atom, a substituted or unsubstituted alkyl group having 1 to 18 carbon atoms, a substituted or unsubstituted alkoxy group having 1 to 18 carbon atoms, a substituted or unsubstituted cycloalkyl group having 6 to 20 ring carbon atoms, a substituted or unsubstituted cycloalkoxy group having 6 to 20 ring carbon atoms, a substituted or unsubstituted alkenyl group having 2 to 10 carbon atoms, a substituted or unsubstituted aryl group having 6 to 14 ring carbon atoms, a substituted or unsubstituted aryloxy group having 6 to 14 ring carbon atoms, a substituted or unsubstituted aralkyl group having 7 to 20 carbon atoms, a substituted or unsubstituted aralkyloxy group having 7 to 20 carbon atoms, a nitro group, an aldehyde group, a cyano group, and a carboxy group;
X₃ is (i) a single bond; (ii) a group selected from the group consisting of a substituted or unsubstituted alkylene group having 1 to 28 carbon atoms, a substituted or unsubstituted alkylidene group having 2 to 28 carbon atoms, a substituted or unsubstituted cycloalkylene group having 5 to 15 ring carbon atoms, a substituted or unsubstituted cycloalkylidene group having 3 to 26 ring carbon atoms, a substituted or unsubstituted arylene group having 6 to 20 ring carbon atoms, -S-, - SO-, -SO₂-, -O-, and -CO-; or (iii) a divalent group formed by linking two or more groups selected from the group described in (ii) above; and
each * represents a bond.

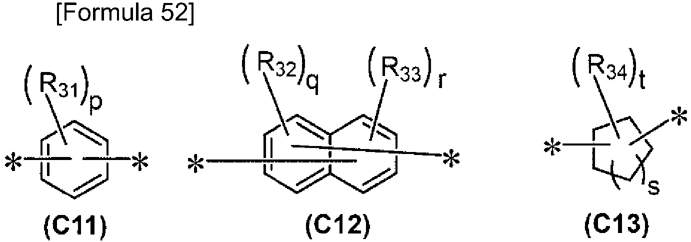

In the formulae (C11), (C12), and (C13):
R₃₁ to R₃₄ are each independently selected from the group consisting of a hydrogen atom, a halogen atom, a substituted or unsubstituted alkyl group having 1 to 18 carbon atoms, a substituted or unsubstituted alkoxy group having 1 to 18 carbon atoms, a substituted or unsubstituted cycloalkyl group having 6 to 20 ring carbon atoms, a substituted or unsubstituted cycloalkoxy group having 6 to 20 ring carbon atoms, a substituted or unsubstituted alkenyl group having 2 to 10 carbon atoms, a substituted or unsubstituted aryl group having 6 to 14 ring carbon atoms, a substituted or unsubstituted aryloxy group having 6 to 14 ring carbon atoms, a substituted or unsubstituted aralkyl group having 7 to 20 carbon atoms, a substituted or unsubstituted aralkyloxy group having 7 to 20 carbon atoms, a nitro group, an aldehyde group, a cyano group, and a carboxy group;
p is 4;
q is 2, 3, or 4, r is 2, 3, or 4, and q + r is 6;
s is 1, 2, 3, 4, 5, 6, 7, or 8, and t is 2s + 6;
a plurality of R₃₁ are identical or different from each other;
a plurality of R₃₂ are identical or different from each other;
a plurality of R₃₃ are identical or different from each other;
a plurality of R₃₄ are identical or different from each other; and
each * represents a bond.

In one embodiment of the resin and the copolymer according to the exemplary embodiment: when s in the group represented by the formula (C13) is 1, the group represented by the formula (C13) is represented by a formula (C131) below; when s is 2, the group represented by the formula (C13) is represented by a formula (C132) below; when s is 3, the group represented by the formula (C13) is represented by a formula (C133) below; and when s is 8, the group represented by the formula (C13) is represented by a formula (C138) below.

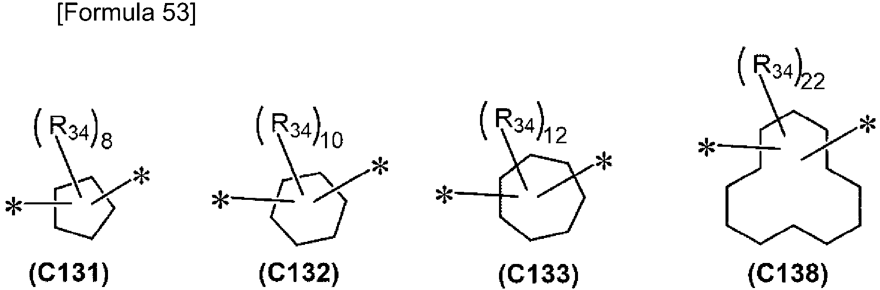

In the formulae (C131), (C132), (C133), and (C138), each R₃₄ represents the same as R₃₄ in the formula (C13).

The resin and the copolymer according to the exemplary embodiment may include other structural units than the aforementioned structural units. Examples of the other structural units include a terminal structure derived from an end-capping agent described later, and a structural unit containing a silicon atom.

The resin according to one embodiment of the exemplary embodiment is a polycarbonate resin.

The copolymer according to one embodiment of the exemplary embodiment is a polycarbonate copolymer.

### Reduced Viscosity

In one embodiment of the resin and the copolymer according to the exemplary embodiment, a reduced viscosity of the resin or the copolymer is 0.80 dL/g or less. In the exemplary embodiment, the reduced viscosity of the resin or the copolymer is a reduced viscosity at 20 degrees C of a solution having a concentration of 0.5 g/dL, in which methylene chloride is used as a solvent and the resin or the copolymer is used as a solute.

In one embodiment of the resin and the copolymer according to the exemplary embodiment, the reduced viscosity of the resin or the copolymer is 0.75 dL/g or less, or 0.70 dL/g or less.

In one embodiment of the resin and the copolymer according to the exemplary embodiment, the reduced viscosity of the resin or the copolymer is 0.30 dL/g or more, or 0.35 dL/g or more.

### Dielectric Properties

There are various methods for evaluating dielectric properties. A commonly used method is a cavity resonator perturbation method (hereinafter referred to as a cavity resonator method), which uses an electric field aligned with a sample to evaluate the dielectric properties. However, the electric field deflects to the outside of the sample at both ends of the sample. Since there is no known quantitative explanation for the imperfection, the dielectric constant is typically calculated by assuming that the electric field passes through the entire sample. Therefore, values of the dielectric properties are calculated assuming that the electric field is applied to the entire sample, even though no electric field is applied to either end of the sample. The dielectric constant is thus measured to be low. Unlike the cavity resonance method, a split cylinder resonator perturbation method (hereinafter referred to as a split cylinder method), which uses a circular electric field along a sample surface for measurement, does not cause errors due to the deflection of the electric field at both ends of the sample. Therefore, the split cylinder method outputs a dielectric property value closer to the true value than the cavity resonance method.

A dielectric constant Dk of the resin and the copolymer according to one embodiment of the exemplary embodiment is preferably 2.80 or less, preferably 2.75 or less, more preferably 2.70 or less, still more preferably 2.65 or less, still further more preferably 2.60 or less, and yet still further more preferably 2.50 or less. Herein, the dielectric constant Dk of the resin and the copolymer is a value measured at room temperature (23 degrees C) and at a frequency of 10 GHz using a split-cylinder resonator.

A dissipation factor Df of the resin and the copolymer according to one embodiment of the exemplary embodiment is preferably 0.02000 or less, preferably 0.00700 or less, preferably 0.00500 or less, preferably 0.00350 or less, more preferably 0.00300 or less, still more preferably 0.00250 or less, still further more preferably 0.00200 or less, and yet still further more preferably 0.00140 or less. Herein, the dissipation factor Df of the resin and the copolymer is a value measured at room temperature (23 degrees C) and at a frequency of 10 GHz using a split-cylinder resonator.

Since the dielectric constant Dk and the dissipation factor Df of the resin and the copolymer according to the exemplary embodiment are equal to or less than the aforementioned upper limit values, the use of the resin and the copolymer according to the exemplary embodiment as an electronic substrate material can reduce loss of electrical signals in the electronic substrate.

### Viscosity-Average Molecular Weight

In view of solution viscosity, a viscosity-average molecular weight Mv of the resin and the copolymer according to one embodiment of the exemplary embodiment is preferably in a range from 500 to 100,000, more preferably in a range from 1,000 to 80,000, still more preferably in a range from 1,000 to 70,000, and still further more preferably in a range from 1,000 to 30,000.

Herein, the viscosity-average molecular weight Mv is calculated according to the following Schnell's equation, in which a solution is prepared by dissolving a resin or copolymer in methylene chloride as a solvent, the intrinsic viscosity [η] of the solution at 20 degrees C is measured using an Ubbelohde viscometer, and the measured value is used in the equation.$\left[η\right] = 1.23 \times {10}^{- 5} {Mv}^{0.83}$

### Thermal Expansion Coefficient

Since the resin and the copolymer according to the exemplary embodiment preferably have a low thermal expansion coefficient, the thermal expansion coefficient at a temperature from 40 degrees C to 100 degrees C of the resin and the copolymer according to one embodiment of the exemplary embodiment is preferably 150 [ppm/K] or less, preferably 120 [ppm/K] or less, more preferably 115 [ppm/K] or less, still more preferably 100 [ppm/K] or less, still further more preferably 90 [ppm/K] or less, and yet still further more preferably 80 [ppm/K] or less. The thermal expansion coefficient can be measured by the method described in Examples.

### Glass Transition Temperature (Tg)

The resin and the copolymer according to the exemplary embodiment preferably have a glass transition temperature (Tg) of 80 degrees C or higher, more preferably 100 degrees C or higher, still more preferably 120 degrees C or higher, still further more preferably 150 degrees C or higher, and yet still further more preferably 170 degrees C or higher. The glass transition temperature can be measured by the method described in Examples.

### Description of Substituents etc.

In the resin and the copolymer according to the exemplary embodiment, examples of the halogen atom include a fluorine atom, a chlorine atom, a bromine atom, and an iodine atom.

In the resin and the copolymer according to the exemplary embodiment, examples of the alkyl group include a methyl group, an ethyl group, an n-propyl group, an isopropyl group, a butyl group, a sec-butyl group, a tert-butyl group, various pentyl groups, and various hexyl groups. Herein, when the name of a substituent is preceded by the term "various," the "various" indicates that both linear and all branched chain groups are included, and the same applies hereinafter.

In the resin and the copolymer according to the exemplary embodiment, examples of the substituted alkyl group include a trifluoromethyl group.

In the resin and the copolymer according to the exemplary embodiment, the number of carbon atoms of the alkyl group is preferably, for instance, in a range from 1 to 28, in a range from 1 to 20, in a range from 1 to 18, in a range from 1 to 10, or in a range from 1 to 5.

Herein, a numerical range expressed as "AA to BB" means a range including a numerical value AA described in the former part of "AA to BB" as the lower limit value and a numerical value BB described in the latter part of "AA to BB" as the upper limit value.

In the resin and the copolymer according to the exemplary embodiment, examples of the alkylene group include a methylene group, an ethylene group, a trimethylene group, a tetramethylene group, and a hexamethylene group.

In the resin and the copolymer according to the exemplary embodiment, the number of carbon atoms of the alkylene group is preferably, for instance, in a range from 1 to 28, in a range from 1 to 20, in a range from 1 to 18, in a range from 1 to 10, or in a range from 1 to 5.

In the resin and the copolymer according to the exemplary embodiment, examples of the alkylidene group include an ethylidene group and an isopropylidene group.

In the resin and the copolymer according to the exemplary embodiment, the number of carbon atoms of the alkylidene group is preferably, for instance, in a range from 2 to 28, in a range from 2 to 20, in a range from 2 to 18, in a range from 2 to 10, or in a range from 2 to 5.

In the resin and the copolymer according to the exemplary embodiment, examples of the alkoxy group include a methoxy group, an ethoxy group, a propoxy group, an isopropoxy group, a butoxy group, an isobutoxy group, a sec-butoxy group, a tert-butoxy group, various pentyloxy groups, and various hexyloxy groups.

In the resin and the copolymer according to the exemplary embodiment, the number of carbon atoms of the alkoxy group is, for instance, in a range from 1 to 20, in a range from 1 to 18, in a range from 1 to 10, or in a range from 1 to 5.

In the resin and the copolymer according to the exemplary embodiment, examples of the cycloalkyl group include a cyclopropyl group, a cyclobutyl group, a cyclopentyl group, a cyclohexyl group, a cycloheptyl group, an adamantyl group, and a norbornyl group.

In the resin and the copolymer according to the exemplary embodiment, the number of ring carbon atoms of the cycloalkyl group is preferably, for instance, in a range from 3 to 26, in a range from 3 to 20, or in a range from 6 to 20.

In the resin and the copolymer according to the exemplary embodiment, examples of the cycloalkylene group include a cyclopentanediyl group, a cyclohexanediyl group, and a cyclooctanediyl group.

In the resin and the copolymer according to the exemplary embodiment, the number of ring carbon atoms of the cycloalkylene group is preferably, for instance, in a range from 5 to 15 or in a range from 5 to 10.

In the resin and the copolymer according to the exemplary embodiment, examples of the cycloalkylidene group include a cyclohexylidene group, a 3,5,5-trimethylcyclohexylidene group, and a 2-adamantylidene group.

In the resin and the copolymer according to the exemplary embodiment, the number of ring carbon atoms of the cycloalkylidene group is preferably, for instance, in a range from 3 to 26, in a range from 5 to 15, or in a range from 5 to 10.

In the resin and the copolymer according to the exemplary embodiment, examples of the cycloalkoxy group include a cycloalkoxy group in which the cycloalkyl moiety is the aforementioned cycloalkyl group, that is, a group represented by -O-Arx in which Arx is the aforementioned cycloalkyl group.

In the resin and the copolymer according to the exemplary embodiment, the number of ring carbon atoms of the cycloalkoxy group is preferably in a range from 3 to 20 or in a range from 6 to 20.

In the resin and the copolymer according to the exemplary embodiment, examples of the alkenyl group include an ethenyl group (vinyl group), a 1-propenyl group, a 2-propenyl group (allyl group), a butenyl group, a pentenyl group, and a hexenyl group.

In the resin and the copolymer according to the exemplary embodiment, the number of carbon atoms of the alkenyl group is preferably, for instance, in a range from 2 to 10 or in a range from 2 to 6.

In the resin and the copolymer according to the exemplary embodiment, examples of the alkynyl group include an ethynyl group, a 1-propynyl group, a 2-propynyl group, a 1-butynyl group, and a 3-hexynyl group.

In the resin and the copolymer according to the exemplary embodiment, the number of carbon atoms of the alkynyl group is preferably, for instance, in a range from 2 to 10 or in a range from 2 to 6.

In the resin and the copolymer according to the exemplary embodiment, examples of the aryl group include a phenyl group, a biphenyl group, a naphthyl group, an antryl group, and a phenanthryl group.

In the resin and the copolymer according to the exemplary embodiment, examples of the substituted aryl group include a 2-methylphenyl group, a 3-methylphenyl group, a 4-methylphenyl group, a 4-ethylphenyl group, a dichlorophenyl group, and a methylnaphthyl group.

In the resin and the copolymer according to the exemplary embodiment, the number of ring carbon atoms of the aryl group is preferably, for instance, in a range from 6 to 20, in a range from 6 to 14, or in a range from 6 to 10.

In the resin and the copolymer according to the exemplary embodiment, examples of the arylene group include a phenylene group, a naphthylene group, an anthracenediyl group, a biphenylene group, and a terphenyldiyl group.

In one embodiment of the resin and the copolymer according to the exemplary embodiment, the number of ring carbon atoms of the arylene group is preferably, for instance, in a range from 6 to 20, in a range from 6 to 14, or in a range from 6 to 10.

In the resin and the copolymer according to the exemplary embodiment, examples of the aryloxy group include a phenoxy group and a naphthyloxy group.

In the resin and the copolymer according to the exemplary embodiment, examples of the substituted aryloxy group include a tolyloxy group.

In the resin and the copolymer according to the exemplary embodiment, the number of ring carbon atoms of the aryloxy group is preferably, for instance, in a range from 6 to 14 or in a range from 6 to 10.

In the resin and the copolymer according to the exemplary embodiment, examples of the aralkyl group include a phenylmethyl group and a phenylethyl group.

In the resin and the copolymer according to the exemplary embodiment, the number of carbon atoms of the aralkyl group is preferably, for instance, in a range from 7 to 20 or in a range from 7 to 15.

In the resin and the copolymer according to the exemplary embodiment, examples of the aralkyloxy group include an aralkyloxy group in which the aralkyl moiety is the aforementioned aralkyl group, that is, a group represented by -O-Ary in which Ary is the aforementioned aralkyl group.

In the resin and the copolymer according to the exemplary embodiment, the number of carbon atoms of the aralkyloxy group is preferably, for instance, in a range from 7 to 20 or in a range from 7 to 15.

In the resin and the copolymer according to the exemplary embodiment, the heteroaryl group includes at least one hetero atom as a ring atom. For instance, the heteroaryl group may include one, two, or three hetero atoms as ring atoms. The hetero atom included in the heteroaryl group as a ring atom is at least one atom selected from the group consisting of a nitrogen atom, an oxygen atom, a sulfur atom, a silicon atom, a phosphorus atom, and a boron atom. When the heteroaryl group includes a plurality of hetero atoms as ring atoms, the plurality of hetero atoms are identical or different from each other.

In the resin and the copolymer according to the exemplary embodiment, examples of the heteroaryl group include a pyrrolyl group, an imidazolyl group, a furyl group, a thienyl group, a pyridinyl group, a pyrazinyl group, a pyrimidinyl group, a pyridazinyl group, a triazinyl group, an indolyl group, a benzofuranyl group, a benzothienyl group, a quinolyl group, an isoquinolyl group, a phenanthrolinyl group, and an acridinyl group.

In the resin and the copolymer according to the exemplary embodiment, the number of ring atoms of the heteroaryl group is preferably in a range from 5 to 20, in a range from 5 to 14, or in a range from 5 to 10.

In the resin and the copolymer according to the exemplary embodiment, examples of the monovalent aromatic hydrocarbon group include the aforementioned aryl group.

In the resin and the copolymer according to the exemplary embodiment, examples of the divalent aromatic hydrocarbon group include a divalent group derived by removing one hydrogen atom from an aryl ring of the aforementioned aryl group.

In the resin and the copolymer according to the exemplary embodiment, examples of the monovalent cyclic aliphatic hydrocarbon group include saturated or unsaturated alicyclic groups. The number of carbon atoms of the alicyclic group is, for instance, in a range from 3 to 20, preferably in a range from 3 to 12, more preferably in a range from 4 to 8. Specific examples of the saturated or unsaturated alicyclic group include: cycloalkyl groups such as cyclopropyl, cyclobutyl, cyclopentyl, cyclohexyl, cycloheptyl, adamantyl, and norbornyl, which are saturated alicyclic groups; and cycloalkenyl groups such as cyclopropenyl, cyclobutenyl, cyclopentenyl, cyclohexenyl, and cycloheptenyl, which are unsaturated alicyclic groups. It should be noted that the unsaturated alicyclic group includes no aromatic group.

In the resin and the copolymer according to the exemplary embodiment, examples of the divalent cyclic aliphatic hydrocarbon group include a divalent group derived by removing one hydrogen atom from a ring of the aforementioned saturated or unsaturated alicyclic group.

In the resin and the copolymer according to the exemplary embodiment, examples of the monovalent acyclic aliphatic hydrocarbon group include the aforementioned alkyl group.

In the resin and the copolymer according to the exemplary embodiment, examples of the divalent acyclic aliphatic hydrocarbon group include a divalent group derived by removing one hydrogen atom from an alkyl chain of the aforementioned alkyl group.

In the resin and the copolymer according to the exemplary embodiment, the acyclic aliphatic hydrocarbon group includes a linear aliphatic hydrocarbon group and a branched aliphatic hydrocarbon group.

Herein , substituents for a "substituted or unsubstituted" group are bonded to each other to form a monocyclic ring, bonded to each other to form a fused ring, or not bonded to each other. Here, a case where substituents for a "substituted or unsubstituted" group are bonded to each other to form a monocyclic ring, or bonded to each other to form a fused ring also includes a case where substituents are bonded to each other to form a polycyclic group. The polycyclic group is preferably a bicyclic group, a tricyclic group, or a tetracyclic group.

With respect to groups derived from cycloalkanes (such as a cycloalkyl group, a cycloalkylene group, and a cycloalkylidene group), a case where substituents for "substituted or unsubstituted" groups are bonded to each other to form a polycyclic group is exemplified by monovalent or divalent groups derived from bicycloalkanes, tricycloalkanes, and tetracycloalkanes.

Herein, substituents as referred to in "substituted" in the phrase "substituted or unsubstituted" group are each independently preferably at least one substituent selected from the group consisting of an alkyl group, a cycloalkyl group, an alkoxy group, an aryl group, an aryloxy group, and a halogen atom. Specific examples of these substituents include groups similar to the specific examples described above. Further, herein, the term "unsubstituted" in the phrase "substituted or unsubstituted" means that no substitution with the aforementioned substituents is present and a hydrogen atom is bonded.

Herein, in specific examples of compounds, D may represent a deuterium atom, Me may represent a methyl group, Ph may represent a phenyl group, and tBu may represent a tert-butyl group.

Herein, the preferred requirements can be optionally adopted, and combinations of the preferred ones can be said to be more preferable.

### Method for Producing Resin and Copolymer

### Dihydroxy Phenol Compound

The resin and the copolymer according to the exemplary embodiment can preferably be produced using a dihydroxy phenol compound (ma) represented by a formula (MA1) below. The structural unit represented by the formula (A1) is derived from the dihydroxy phenol compound (ma).

Accordingly, the exemplary embodiment also provides for use of the dihydroxy phenol compound (ma) represented by the formula (MA1) below for producing the resin and the copolymer according to the exemplary embodiment.

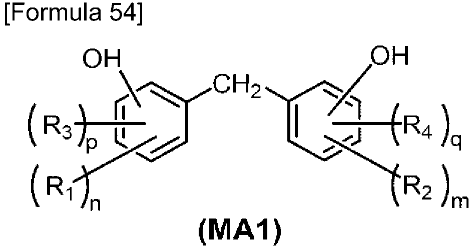

In the formula (MA1), R₁, R₂, R₃, R₄, m, n, p, and q respectively represent the same as R₁, R₂, R₃, R₄, m, n, p, and q in the formula (A1).

The method for producing the resin and the copolymer (the resin production method and the copolymer production method) according to the exemplary embodiment preferably includes a polymerization step of polymerizing the resin or the copolymer using the compound represented by the formula (MA1).

In the method for producing the resin and the copolymer according to the exemplary embodiment, the polymerization step is preferably performed without causing the compound represented by the formula (MA1) to coexist with phosgene.

In one embodiment of the method for producing the resin and the method for producing the copolymer according to the exemplary embodiment, the dihydroxy phenol compound (ma) represented by the formula (MA1) is at least one selected from the group consisting of dihydroxy phenol compounds represented by formulae (MA10), (MA20), and (MA30) below.

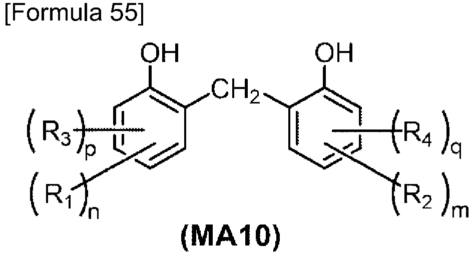

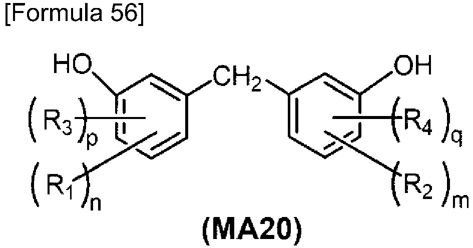

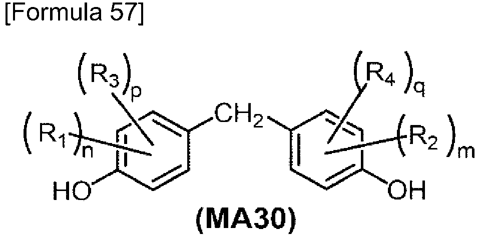

In the formulae (MA10), (MA20), and (MA30), R₁, R₂, R₃, R₄, n, m, p, and q respectively represent the same as R₁, R₂, R₃, R₄, n, m, p, and q in the formula (A1).

In one embodiment of the method for producing the resin and the method for producing the copolymer according to the exemplary embodiment, the dihydroxy phenol compound (ma) represented by the formula (MA1) is represented by a formula (MA11) below.

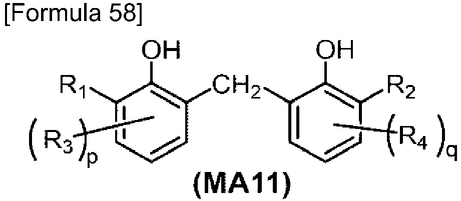

In the formula (MA11), R₁, R₂, R₃, R₄, p, and q respectively represent the same as R₁, R₂, R₃, R₄, p, and q in the formula (A1).

In one embodiment of the method for producing the resin and the method for producing the copolymer according to the exemplary embodiment, the dihydroxy phenol compound (ma) represented by the formula (MA1) is represented by a formula (MA12) below.

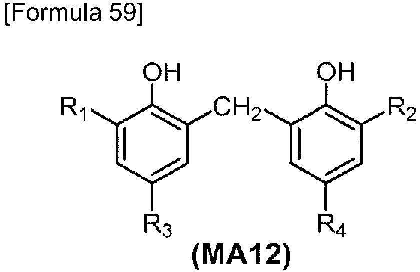

In the formula (MA12), R₁, R₂, R₃, and R₄ respectively represent the same as R₁, R₂, R₃, and R₄ in the formula (A1).

### Method for Producing Polycarbonate Resin and Polycarbonate Copolymer

The resin and the copolymer including the structural unit represented by the formula (A1) as a polycarbonate repeating unit (i.e., the repeating unit represented by the formula (PC-AB1)) can be produced, for instance, by using the dihydroxy phenol compound (ma) represented by the formula (MA1) as the dihydroxy phenol compound, according to a known method for producing a polycarbonate resin. Examples of the method for producing the polycarbonate resin and the polycarbonate copolymer include production methods (P1-1), (P1-2), and (P1-3) below.

### Production Method (P1-1)

The production method (P1-1) is an interfacial polymerization method (phosgene method), in which a dihydroxy phenol compound and phosgene are reacted in the presence of an organic solvent inert to the reaction and an alkaline aqueous solution, followed by the addition of a polymerization catalyst such as a tertiary amine or a quaternary ammonium salt to carry out the polymerization.

### Production Method (P1-2)

The production method (P1-2) is a melt polymerization method (ester-exchange method), in which a dihydroxy phenol compound and a carbonate diester are subjected to ester exchange reaction in a molten state without using a solvent, by adding a basic catalyst.

### Production Method (P1-3)

The production method (P1-3) is a pyridine method, in which a dihydroxy phenol compound is dissolved in pyridine or in a mixed solution of pyridine and an inert solvent, and phosgene is introduced to directly produce the polycarbonate resin.

In the above reactions, for instance, at least one additive selected from the group consisting of a molecular weight regulator (end-capping agent) and a branching agent is used, if necessary.

As the method for producing the polycarbonate resin and the polycarbonate copolymer according to the exemplary embodiment, a production method (P1-4) below is preferable.

### Production Method (P1-4)

The production method (P1-4) is a method for producing an aromatic polycarbonate resin, which includes a step of subjecting a dihydroxy phenol compound and a polycarbonate oligomer to interfacial polycondensation in the presence of a water-insoluble organic solvent and an aqueous solution of an alkaline compound, in which the dihydroxy phenol compound includes the dihydroxy phenol compound (ma) represented by the formula (MA1).

Specifically, in the case of the interfacial polymerization method of the production method (P1-1) or (P1-4), a previously prepared polycarbonate oligomer described later is dissolved in a water-insoluble organic solvent (such as methylene chloride), an aqueous solution of an alkaline compound of a dihydroxy phenol compound (such as an aqueous sodium hydroxide solution) is added, a tertiary amine (such as triethylamine) or a quaternary ammonium salt (such as trimethylbenzylammonium chloride) is used as a polymerization catalyst, and, if necessary, interfacial polycondensation is carried out in the presence of an end-capping agent (a monohydric phenol such as p-tert-butylphenol), thereby producing the polycarbonate resin and the polycarbonate copolymer according to the exemplary embodiment. Further, in the case of the above-described interfacial polymerization method, the polycarbonate resin and the polycarbonate copolymer according to the exemplary embodiment can be produced by copolymerizing a dihydric phenol with phosgene, a carbonate ester, or a chloroformate.

The polycarbonate oligomer can be produced by reacting a dihydroxy phenol compound with a carbonate precursor (e.g., phosgene or triphosgene) in an organic solvent such as methylene chloride, chlorobenzene, or chloroform. When producing the polycarbonate oligomer by the ester-exchange method, the polycarbonate oligomer can also be produced by reacting a dihydroxy phenol compound with a carbonate precursor such as diphenyl carbonate.

In the method for producing the polycarbonate resin and the polycarbonate copolymer according to the exemplary embodiment, the dihydric phenol includes the dihydroxy phenol compound (ma) represented by the formula (MA1) from which the structural unit represented by the formula (A1) is derived.

In one embodiment of the method for producing the polycarbonate resin and the polycarbonate copolymer according to the exemplary embodiment, the dihydric phenol further includes a dihydroxy phenol compound (md) represented by a formula (MD1) below, from which the structural unit represented by the formula (D1) is derived. The dihydroxy phenol compound (md) is a compound different from the dihydroxy phenol compound (ma).

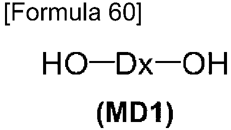

In the formula (MD1), Dx represents the same as Dx in the formula (D1).

In one embodiment of the method for producing the polycarbonate resin and the polycarbonate copolymer according to the exemplary embodiment, Dx is a group represented by the formula (D11).

In one embodiment of the method for producing the polycarbonate resin and the polycarbonate copolymer according to the exemplary embodiment, Dx is a group represented by the formula (D111), (D112), (D113), or (D118).

In one embodiment of the method for producing the polycarbonate resin and the polycarbonate copolymer according to the exemplary embodiment, as the dihydroxy phenol compound (md), at least one selected from the group consisting of dihydroxy phenol compounds represented by formulae (MD111), (MD112), (MD113), and (MD118) below is preferably used.

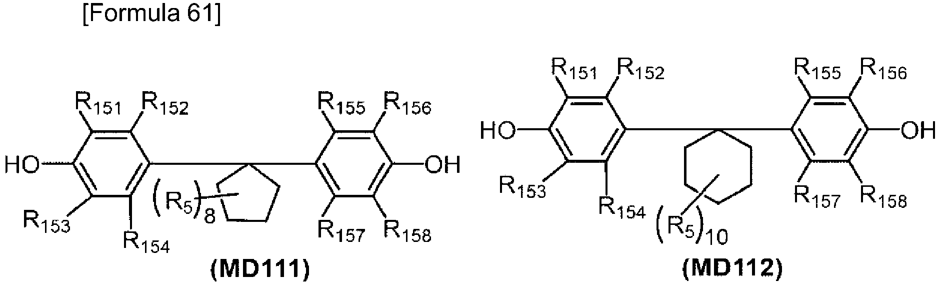

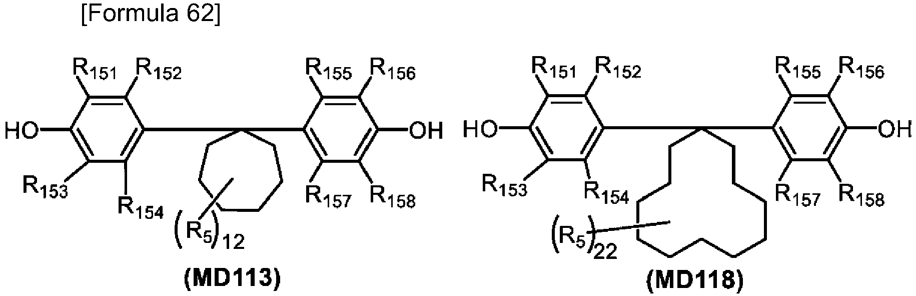

In the formulae (MD111), (MD112), (MD113), and (MD118), R₁₅₁ to R₁₅₈ respectively represent the same as R₁₅₁ to R₁₅₈ in the formula (D2), and a plurality of R₅ each independently represent the same as R₅ in the formula (D11).

Examples of the dihydroxy phenol compound (md) include bis(hydroxyphenyl)alkane dihydric phenols, bis(hydroxyphenyl)cycloalkane dihydric phenols, dihydroxybiphenyl compounds, dihydroxybenzene compounds, dihydroxynaphthalene compounds, bis(4-hydroxyphenyl)oxide, bis(4-hydroxyphenyl)sulfide, bis(4-hydroxy-3-methylphenyl)sulfide, bis(4-hydroxyphenyl)ether, bis(3-fluoro-4-hydroxyphenyl)ether, bis(4-hydroxyphenyl)sulfone, bis(4-hydroxy-3-methylphenyl)sulfone, bis(4-hydroxyphenyl)sulfoxide, and 4,4'-dihydroxybenzophenone.

Examples of the bis(hydroxyphenyl)alkane dihydric phenols include bis(4-hydroxyphenyl)methane, bis(4-hydroxy-3-methylphenyl)methane, 1,1-bis(4-hydroxyphenyl)-1,1-diphenylmethane, 1,1-bis(2-tert-butyl-4-hydroxy-5-methylphenyl)-1-phenylmethane, 1,1-bis(4-hydroxyphenyl)-1-phenylmethane, bis(3-chloro-4-hydroxyphenyl)methane, bis(3,5-dibromo-4-hydroxyphenyl)methane, 1,1-bis(4-hydroxyphenyl)ethane, 1,2-bis(4-hydroxyphenyl)ethane, 2-(4-hydroxy-3-methylphenyl)-2-(4-hydroxyphenyl)-1-phenylethane, 1,1-bis(4-hydroxyphenyl)-1-phenylethane, 1,1-bis(2-tert-butyl-4-hydroxy-3-methylphenyl)ethane, 1-phenyl-1,1-bis(3-fluoro-4-hydroxyphenyl)ethane, 2,2-bis(4-hydroxyphenyl)propane [bisphenol A (BPA)], 2,2-bis(4-hydroxy-3,5-dimethylphenyl)propane, 1,1-bis(3-cyclohexyl-4-hydroxyphenyl)propane, 1,1-bis(4-hydroxy-3-phenylphenyl)propane, 2,2-bis(4-hydroxy-3-methylphenyl)propane, 2,2-bis(4-hydroxy-2-methylphenyl)propane, 1,1-bis(2-tert-butyl-4-hydroxy-5-methylphenyl)propane, 2,2-bis(3-chloro-4-hydroxyphenyl)propane, 2,2-bis(3-fluoro-4-hydroxyphenyl)propane, 2,2-bis(3-bromo-4-hydroxyphenyl)propane, 2,2-bis(3,5-difluoro-4-hydroxyphenyl)propane, 2,2-bis(3,5-dichloro-4-hydroxyphenyl)propane, 2,2-bis(3,5-dibromo-4-hydroxyphenyl)propane, 2,2-bis(3-bromo-4-hydroxy-5-chlorophenyl)propane, 2,2-bis(3-hydroxyphenyl)hexafluoropropane, 2,2-bis(3-phenyl-4-hydroxyphenyl)propane, 1,1-bis(2-butyl-4-hydroxy-5-methylphenyl)butane, 1,1-bis(2-tert-butyl-4-hydroxy-5-methylphenyl)butane, 1,1-bis(2-tert-butyl-4-hydroxy-5-methylphenyl)isobutane, 1,1-bis(2-tert-amyl-4-hydroxy-5-methylphenyl)butane, 2,2-bis(4-hydroxy-3-methylphenyl)butane, 2,2-bis(4-hydroxyphenyl)butane, 2,2-bis(3,5-dichloro-4-hydroxyphenyl)butane, 2,2-bis(3,5-dibromo-4-hydroxyphenyl)butane, 2,2-bis(4-hydroxyphenyl)octane, 4,4-bis(4-hydroxyphenyl)heptane, and 1,1-bis(2-tert-butyl-4-hydroxy-5-methylphenyl)heptane.

Examples of the bis(hydroxyphenyl)cycloalkane dihydric phenols include 1,1-bis(4-hydroxyphenyl)cyclopentane, 1,1-bis(4-hydroxyphenyl)cyclohexane, 1,1-bis(4-hydroxy-3-methylphenyl)cyclohexane, 1,1-bis(4-hydroxyphenyl)-3,3,5-trimethylcyclohexane, 1,1-bis(4-hydroxy-3,5-dimethylphenyl)-3,3,5-trimethylcyclohexane, 1,1-bis(3-cyclohexyl-4-hydroxyphenyl)cyclohexane, 1,1-bis(3-phenyl-4-hydroxyphenyl)cyclohexane, 1,1-bis(4-hydroxy-3-phenylphenyl)cyclohexane, 1,1-bis(4-hydroxyphenyl)cyclododecane, 1,1-bis(4-hydroxy-3-methylphenyl)cyclododecane, and 1,1-bis(4-hydroxy-3,5-dimethylphenyl)cyclododecane.

Examples of the dihydroxybiphenyl compounds include 4,4'-dihydroxybiphenyl, 3,3'-difluoro-4,4'-dihydroxybiphenyl, 4,4'-dihydroxy-3,3'-dimethylbiphenyl, 4,4'-dihydroxy-2,2'-dimethylbiphenyl, 4,4'-dihydroxy-2,2',5,5'-dimethylbiphenyl, and 4,4'-dihydroxy-3,3'-dicyclohexylbiphenyl.

Examples of the dihydroxybenzene compounds include hydroquinone, resorcinol, and catechol.

Examples of the dihydroxynaphthalene compounds include 2,6-dihydroxynaphthalene and 1,4-dihydroxynaphthalene.

These dihydroxy phenol compounds (md) may be used alone or as a mixture of two or more thereof.

In one embodiment of the method for producing the polycarbonate resin and copolymer according to the exemplary embodiment, only the dihydroxy phenol compound (md) may be used as the dihydroxy phenol compound for producing the above-described polycarbonate oligomer. In this case, in the interfacial polycondensation step, both the dihydroxy phenol compound (ma) and the dihydroxy phenol compound (md) may be used together, or only the dihydroxy phenol compound (ma) may be used.

In order to adjust the molecular weight of the polycarbonate resin and copolymer according to the exemplary embodiment, an end-capping agent (molecular weight regulator) can be used. Examples of the end-capping agent include monohydric phenols such as phenol, p-cresol, p-tert-butylphenol, p-tert-octylphenol, p-cumylphenol, p-nonylphenol, m-pentadecylphenol, and p-tert-amylphenol. These monohydric phenols may be used alone or as a combination of two or more thereof.

### Method for Producing Polyester Resin and Polyester Copolymer

The resin and the copolymer including the structural unit represented by the formula (A1) as a polyester repeating unit (i.e., the structural unit represented by the formula (PE-AC1)) can be produced, for instance, by using the dihydroxy phenol compound (ma) represented by the formula (MA1) as the dihydroxy phenol compound, according to a known method for producing a polyester resin. As the method for producing a polyester resin, for instance, there may be mentioned a method in which a bisphenol for forming a repeating unit derived from bisphenol and a dicarboxylic acid for forming a repeating unit derived from dicarboxylic acid are subjected to polycondensation. Examples of the polycondensation method include solution polymerization, melt polymerization, and interfacial polymerization.

In one embodiment of the method for producing the polyester resin and copolymer according to the exemplary embodiment, as the bisphenol for forming a repeating unit derived from bisphenol, at least one dihydroxy phenol compound (ma) selected from the group consisting of dihydroxy phenol compounds represented by the formulae (MA1), (MA10), (MA11), (MA12), (MA20), and (MA30) may be used.

In one embodiment of the method for producing the polyester resin and copolymer according to the exemplary embodiment, not only the dihydroxy phenol compound (ma) but also the dihydroxy phenol compound (md) represented by the formula (MD1) may additionally be used as the bisphenol for forming a repeating unit derived from bisphenol.

In one embodiment of the method for producing the polyester resin and copolymer according to the exemplary embodiment, a dicarboxylic acid compound (mc) represented by a formula (MC1) below may be used as the dicarboxylic acid for forming a repeating unit derived from dicarboxylic acid.

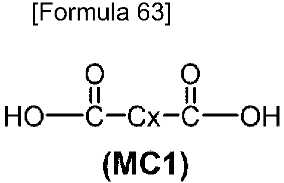

In the formula (MC1), Cx represents the same as Cx in the formula (C1).

In one embodiment of the method for producing the polyester resin and copolymer according to the exemplary embodiment, Cx is a group represented by the formula (C10), (C11), (C12), or (C13).

In one embodiment of the method for producing the polyester resin and copolymer according to the exemplary embodiment, as the dicarboxylic acid compound (mc), at least one selected from the group consisting of dicarboxylic acid compounds represented by formulae (MC10), (MC11), (MC12), and (MC13) below is preferably used.

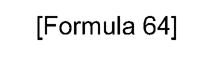

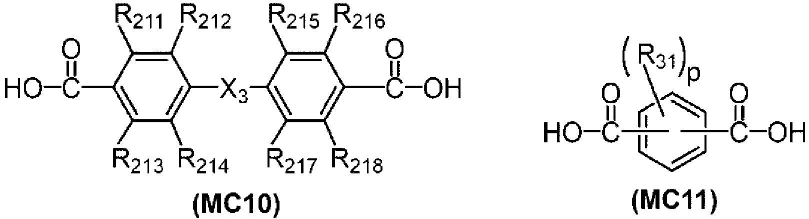

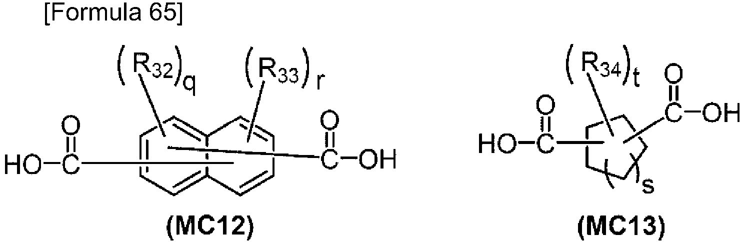

In the formula (MC10), R₂₁₁ to R₂₁₈ and X₃ respectively represent the same as R₂₁₁ to R₂₁₈ and X₃ in the formula (C10);
in the formula (MC11), R₃₁ and p respectively represent the same as R₃₁ and p in the formula (C11);
in the formula (MC12), R₃₂, R₃₃, q, and r respectively represent the same as R₃₂, R₃₃, q, and r in the formula (C12); and
in the formula (MC13), R₃₄, t, and s respectively represent the same as R₃₄, t, and s in the formula (C13).

In one embodiment of the method for producing the polyester resin and copolymer according to the exemplary embodiment, the bisphenol may be used after being derivatized into an aromatic diacetate.

In one embodiment of the method for producing the polyester resin and copolymer according to the exemplary embodiment, the dicarboxylic acid compound (mc) may be used after being derivatized. Examples of derivatives of the dicarboxylic acid compound (mc) include a dicarboxylic acid dichloride, a dicarboxylic acid dimethyl ester, a dicarboxylic acid diethyl ester, and a dicarboxylic acid anhydride. The dicarboxylic acid dichloride is a compound in which the two "-C(=O)-OH" groups of the dicarboxylic acid are substituted with "-C(=O)-Cl" groups. For instance, dichloride of the dicarboxylic acid compound (ma) represented by the formula (MC1) is represented by a formula (MC1-CL) below.

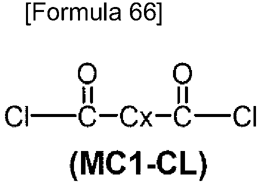

In the formula (MC1-CL), Cx represents the same as Cx in the formula (C1).

In one embodiment of the method for producing the polyester resin and copolymer according to the exemplary embodiment, an end-capping agent may be added during the polycondensation reaction between bisphenol and dicarboxylic acid. Examples of the end-capping agent include p-tert-butylphenol, 2,6-dimethylphenol, and 1H,1H-perfluoro-1-heptanol.

In one embodiment of the method for producing the polyester resin and copolymer according to the exemplary embodiment, either or both of a base and a catalyst may be added during the polycondensation reaction between bisphenol and dicarboxylic acid. Examples of the base include sodium hydroxide. Examples of the catalyst include benzyltributylammonium chloride, ammonium chloride, ammonium bromide, quaternary ammonium salts, triethylamine, and trimethylamine.

### Method for Producing Polyester Polycarbonate Resin and Polyester Polycarbonate Copolymer

The resin and the copolymer including the structural unit represented by the formula (A1) as a polycarbonate repeating unit (i.e., the repeating unit represented by the formula (PC-AB1)) and including a polyester repeating unit can be produced, for instance, by using the dihydroxy phenol compound (ma) represented by the formula (MA1) as the dihydroxy phenol compound, according to a known method for producing a polyester polycarbonate resin.

Further, the resin and the copolymer including the structural unit represented by the formula (A1) as a polyester repeating unit (i.e., the structural unit represented by the formula (PE-AC1)) and including a polycarbonate repeating unit can be produced, for instance, by using the dihydroxy phenol compound (ma) represented by the formula (MA1) as the dihydroxy phenol compound, according to a known method for producing a polyester polycarbonate resin.

The polyester polycarbonate resin and copolymer according to one embodiment of the exemplary embodiment can be produced using the dihydroxy phenol compound (ma) represented by the formula (MA1) and the dicarboxylic acid compound (mc) represented by the formula (MC1). As one embodiment of the method for producing the polyester polycarbonate resin and copolymer, for instance, there may be mentioned a method in which a bisphenol for forming a repeating unit derived from bisphenol, a dicarboxylic acid for forming a repeating unit derived from dicarboxylic acid, and a compound for forming a repeating unit derived from carbonate are subjected to polycondensation. The polyester polycarbonate resin and copolymer according to one embodiment of the exemplary embodiment are produced in the presence of at least one additive selected from the group consisting of acid scavengers, catalysts, molecular weight regulators (such as end-capping agent and branching agent), and solvents, as needed.

In one embodiment, examples of the method for producing the polyester polycarbonate resin and copolymer include: melt polymerization, in which bisphenol, dicarboxylic acid, and diphenyl carbonate are subjected to ester exchange reaction in the presence of a basic catalyst under non-solvent conditions; and interfacial polymerization, in which bisphenol, dicarboxylic acid, and phosgene are reacted in the presence of an organic solvent inert to the reaction and a basic aqueous solution, followed by the addition of a polymerization catalyst such as a tertiary amine or a quaternary ammonium salt. In particular, the method of interfacial polycondensation of bisphenol, dicarboxylic acid chloride, and polycarbonate oligomer in the presence of a non-aqueous organic solvent and a basic compound aqueous solution, similar to the production method (P1-4), is preferable because it is simple, does not cause side reactions, and allows easy molecular weight control.

In one embodiment of the method for producing the polyester polycarbonate resin and copolymer according to the exemplary embodiment, not only the dihydroxy phenol compound (ma) but also the dihydroxy phenol compound (md) represented by the formula (MD1) may additionally be used as the dihydroxy phenol compound. These dihydroxy phenol compounds may be used alone or in combination of two or more.

In one embodiment of the method for producing the polyester polycarbonate resin and copolymer according to the exemplary embodiment, a derivative of the dicarboxylic acid compound (mc) can also be used instead of the dicarboxylic acid compound (mc) represented by the formulae (MC1), (MC10), (MC11), (MC12), and (MC13). Examples of the derivative of the dicarboxylic acid compound (mc) include dicarboxylic acid halides such as dicarboxylic acid dichloride, and derivatives of the dicarboxylic acid compound (mc) exemplified in the above description of the method for producing the polyester resin and copolymer.

One specific example of a reaction scheme suitable for producing the polyester polycarbonate resin and copolymer according to the exemplary embodiment is a two-stage polymerization, which involves performing Steps (P3-1) and (P3-2) below.

### Step (P3-1)

Step (P3-1) as the first stage is a step in which a polycarbonate oligomer is synthesized using a portion of the dihydroxy phenol compound (ma) and a carbonate ester-forming compound.

### Step (P3-2)

Step (P3-2) as the second stage is a step in which the polycarbonate oligomer synthesized in Step (P3-1) is mixed with a reaction system including the remaining portion of the dihydroxy phenol compound (ma) and the dicarboxylic acid compound (mc) or its derivative, and then subjected to a polycondensation reaction.

In one embodiment of the method for producing the polyester polycarbonate resin and copolymer according to the exemplary embodiment, the synthesis of the polycarbonate oligomer in Step (P3-1) as the first stage can be carried out by the following synthesis methods (P3-1a) and (P3-1b) and the like.

### Synthesis Method (P3-1a)

The synthesis method (P3-1a) is a method in which polycondensation is carried out in the presence of a suitable acid scavenger using a carbonate ester-forming compound, such as carbonyl dihalides, haloformates, or carbonate ester compounds. Examples of the carbonyl dihalides include phosgene. Examples of haloformates include chloroformate compounds.

The above-described reaction in which polycondensation is carried out in the presence of an acid scavenger using a carbonate ester-forming compound, such as carbonyl dihalides, haloformates, or carbonate ester compounds, is typically conducted in a solvent. The proportion of the carbonate ester-forming compound to be used may be appropriately adjusted in consideration of the stoichiometric ratio (equivalents) of the reaction. In addition, when using a gaseous carbonate ester-forming compound such as phosgene, a method of introducing it into the reaction system by blowing is preferably employed.

Examples of the acid scavenger used in the synthesis method (P3-1a) include alkali metal hydroxides such as sodium hydroxide and potassium hydroxide, alkali metal carbonates such as sodium carbonate and potassium carbonate, organic bases such as pyridine, or mixtures thereof. The proportion of the acid scavenger to be used may be appropriately determined in consideration of the stoichiometric ratio (equivalents) of the reaction. Specifically, it is preferable to use 2 equivalents or a slightly excess amount of the acid scavenger per mole of the dihydroxy phenol compound (ma) used.

As the solvent used in the synthesis method (P3-1a), a solvent known to be used for the production of polycarbonates may be used either as a single solvent or as a mixed solvent. The solvent is exemplified by hydrocarbon solvents (e.g., xylene) and halogenated hydrocarbon solvents (e.g., methylene chloride and chlorobenzene). In the synthesis method (P3-1a), interfacial polycondensation may be carried out using two immiscible solvents.

In the synthesis method (P3-1a), if desired, a small amount of an antioxidant may be added. Examples of the antioxidant include sodium sulfite and hydrosulfite.

The reaction in the synthesis method (P3-1a) is carried out at a temperature, typically in a range from 0 to 50 degrees C, preferably in a range from 10 to 30 degrees C. The reaction pressure can be either reduced pressure, atmospheric pressure, or elevated pressure, but the reaction may be typically preferably carried out at atmospheric pressure or at about the self-generated pressure of the reaction system. The reaction time depends on factors such as reaction temperature, but is typically in a range from 10 to 60 minutes, preferably in a range from approximately 15 to 30 minutes.

### Synthesis Method (P3-1b)

The synthesis method (P3-1b) is a method in which transesterification reaction is carried out using bisaryl carbonates as the carbonate ester-forming compound.

When using bisaryl carbonate as the carbonate ester-forming compound and synthesizing the polycarbonate oligomer by the transesterification method, suitable reaction schemes include melt polycondensation and solid-phase polycondensation.

Examples of bisaryl carbonates include di-p-tolyl carbonate, phenyl-p-tolyl carbonate, di-p-chlorophenyl carbonate, and dinaphthyl carbonate.

In the synthesis method (P3-1b), when performing melt polycondensation, the dihydroxy phenol compound (ma) and bisaryl carbonate are mixed and reacted in a molten state at high temperature under reduced pressure. The reaction is carried out at a temperature, typically in a range from 150 to 350 degrees C, preferably in a range from 200 to 300 degrees C.

In the synthesis method (P3-1b), when performing solid-phase polycondensation, the dihydroxy phenol compound (ma) and bisaryl carbonate are mixed and heated in a solid state to a temperature equal to or less than the melting point of the resulting polycarbonate oligomer, thereby performing polycondensation. The reaction time depends on factors such as the reaction temperature and degree of vacuum, but is typically in a range from approximately 30 minutes to 2 hours. The reaction is preferably carried out under an inert gas atmosphere such as nitrogen or argon, and, if desired, the aforementioned antioxidant or the like may be added to the reaction.

Next, Step (P3-2) as the second stage in one embodiment of the method for producing the polyester polycarbonate resin and copolymer according to the exemplary embodiment will be described. In Step (P3-2) as the second stage, the ratio of the remaining portion of the dihydroxy phenol compound (ma) and the dicarboxylic acid compound (mc) or its derivative used to prepare the reaction system can be appropriately selected in consideration of the stoichiometric ratio of the polycondensation reaction. There are no particular limitations, but it is generally preferable to use approximately 1 mole of the dicarboxylic acid compound (mc) or its derivative per mole of the dihydroxy phenol compound (ma). The reaction system including the remaining portion of the dihydroxy phenol compound (ma) and the dicarboxylic acid compound (mc) or its derivative is typically prepared by dissolving the remaining portion of the dihydroxy phenol compound (ma) in an aqueous solution of the above-described alkali metal hydroxide or alkali metal carbonate, then mixing it with the dicarboxylic acid compound (mc) or its derivative, which has been dissolved in the above-described organic solvent immiscible with water, and stirring the mixture. In this reaction system, a condensation reaction progresses between the remaining portion of the dihydroxy phenol compound (ma) and the dicarboxylic acid compound (mc) or its derivative, resulting in the formation of a polyester oligomer.

Next, as the reaction in Step (P3-2) as the second stage, a solution of the polycarbonate oligomer synthesized in Step (P3-1) above, preferably, for instance, a solution of polycarbonate oligomer in methylene chloride, is mixed into the system in which the polyester oligomer has been formed, and polycondensation is carried out. The reaction temperature for this polycondensation reaction is typically in a range from approximately 0 to 50 degrees C, preferably in a range from approximately 5 to 20 degrees C. The reaction time is sufficient typically in a range from approximately 5 minutes to 3 hours, preferably in a range from approximately 10 minutes to 1.5 hours. There are no particular restrictions on the reaction pressure, but the reaction can typically and preferably be carried out at atmospheric pressure or with slight pressure. In carrying out this polycondensation reaction, if necessary, at an appropriate time, at least one additive selected from the group consisting of suitable molecular weight regulators, catalysts, and solvents may be added to the reaction system. In this way, the polyester polycarbonate resin and copolymer according to the exemplary embodiment can be obtained.

Additionally, as another example of the two-stage polycondensation method for the polyester polycarbonate resin and copolymer according to the exemplary embodiment, after synthesizing the polycarbonate oligomer in the first stage in the same manner as in Step (P3-1) above, Step (P3-3) below may be performed as the second stage.

### Step (P3-3)

In Step (P3-3), to a solution obtained by dissolving the polycarbonate oligomer synthesized in Step (P3-1) above in an organic solvent that is immiscible with water is added a solution obtained by dissolving the dicarboxylic acid compound (mc) or its derivative in an aqueous solution of the above-described alkali metal hydroxide or alkali metal carbonate. The reaction is then carried out in the presence of at least one of an end-capping agent or a catalyst.

Still another example of the two-stage polycondensation method for the polyester polycarbonate resin and copolymer according to the exemplary embodiment is a two-stage polymerization, which involves performing Steps (P3-4) and (P3-5) below.

### Step (P3-4)

In Step (P3-4) as the first stage, a polyester oligomer is synthesized from a portion of the dihydroxy phenol compound (ma) and the dicarboxylic acid compound (mc) or its derivative, in the same manner as in Step (P3-2) above.

### Step (P3-5)

In Step (P3-5) as the second stage, to a solution in which the polyester oligomer synthesized in Step (P3-4) above is dissolved in an organic solvent is added a solution in which the remaining portion of the dihydroxy phenol compound (ma) is dissolved in an aqueous solution of the above-described alkali metal hydroxide or alkali metal carbonate. The reaction is then carried out in the presence of the carbonate ester-forming compound, and at least one of an end-capping agent or a catalyst.

As the method for producing the polyester polycarbonate resin and copolymer according to the exemplary embodiment, the synthesis method may be selected depending on the desired structure and composition of the polyester polycarbonate.

Examples of the above catalyst usable in the method for producing the polyester polycarbonate resin and copolymer according to the exemplary embodiment include tertiary amines such as triethylamine or quaternary ammonium salts.

Examples of the branching agent usable in the method for producing the resin and the copolymer according to the exemplary embodiment include phloroglucinol, pyrogallol, 1,1,1-tris(4-hydroxyphenyl)methane, 1,1,1-tris(4-hydroxyphenyl)ethane, 1,1,1-tris(4-hydroxyphenyl)propane, 1,1,1-tris(3-methyl-4-hydroxyphenyl)ethane, 4,6-dimethyl-2,4,6-tris(4-hydroxyphenyl)-2-heptene, 4,6-dimethyl-2,4,6-tris(4-hydroxyphenyl)heptane, 2,6-dimethyl-2,4,6-tris(4-hydroxyphenyl)-3-heptene, 1,3,5-tris(2-hydroxyphenyl)benzene, 1,3,5-tris(4-hydroxyphenyl)benzene, tris(4-hydroxyphenyl)-phenylmethane, 2,2-bis[4,4-bis(4-hydroxyphenyl)cyclohexyl]propane, 2,4-bis(4-hydroxyphenylisopropyl)phenol, 2,6-bis(2-hydroxy-5-methylbenzyl)-4-methylphenol, 2-(4-hydroxyphenyl)-2-(2,4-dihydroxyphenyl)propane, α,α',α"-tris(4-hydroxyphenyl)-1,3,5-triisopropylbenzene, 2,6-bis(2-hydroxy-5-methylbenzyl)-4-methylphenol, hexakis[4-(4-hydroxyphenylisopropyl)phenyl]-o-terephthalic acid ester, tetrakis(4-hydroxyphenyl)methane, tetrakis[4-(4-hydroxyphenylisopropyl)phenoxy]methane, 1,4-bis[(4',4"-dihydroxytriphenyl)methyl]benzene, 2,4-dihydroxybenzoic acid, trimesic acid, cyanuric chloride, 3,3-bis(3-methyl-4-hydroxyphenyl)-2-oxo-2,3-dihydroindole, 3,3-bis(4-hydroxyaryl)oxyindole (=isatin bisphenol), 5-chloroisatin, 5,7-dichloroisatin, 5-bromoisatin, and phloroglucide.

Examples of the end-capping agent usable in the method for producing the resin and the copolymer according to the exemplary embodiment include phenol, α-naphthol, β-naphthol, o-cresol, m-cresol, p-cresol, 2,3-xylenol, 2,4-xylenol, 2,5-xylenol, 2,6-xylenol, 3,4-xylenol, 3,5-xylenol, p-ethylphenol, p-propylphenol, p-butylphenol, p-pentylphenol, p-hexylphenol, p-heptylphenol, p-octylphenol, p-nonylphenol, p-decylphenol, p-undecylphenol, p-dodecylphenol, p-isopropylphenol, p-tert-butylphenol, 2,6-dimethyl-p-tert-butylphenol, 2-tert-amyl-4-methylphenol, 3-methyl-6-tert-butylphenol, 2-methyl-4,6-di-tert-butylphenol, 2,4-di-tert-butylphenol, 2,6-di-tert-butyl-4-methylphenol, 4-tert-octylphenol, 4-tert-amylphenol, 2,4,6-tri-tert-butylphenol, p-phenylphenol, 2,6-di-tert-butyl-4-phenylphenol, 2,6-di-sec-butyl-4-methylphenol, o-anisole, m-anisole, p-anisole, o-chlorophenol, m-chlorophenol, p-chlorophenol, o-bromophenol, m-bromophenol, p-bromophenol, p-ethoxyphenol, o-aminophenol, m-aminophenol, p-aminophenol, p-cyanophenol, p-nitrophenol, 3-methyl-6-isopropylphenol, and 2-methyl-5-isopropylphenol. Preferred end-capping agents are p-tert-butylphenol and p-phenylphenol.

In the exemplary embodiment, by using p-tert-butylphenol as the end-capping agent, a resin and a copolymer having a terminal group represented by a formula (T1) below can be produced.

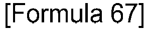

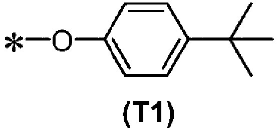

In the formula (T1), * represents a bond with a repeating unit at a terminal of the resin and the copolymer.

The reduced viscosity of the resin and the copolymer according to the exemplary embodiment can be adjusted to a predetermined range by various methods, such as the selection of reaction conditions and adjustment of the amounts of the end-capping agent and branching agent. Additionally, the obtained polyester polycarbonate resin and copolymer can be subjected to at least one of a physical treatment or a chemical treatment as appropriate to obtain the resin and copolymer with a predetermined reduced viscosity. Examples of the physical treatment include mixing and fractionation. Examples of the chemical treatment include polymer reactions, crosslinking treatments, and partial degradation treatments.

### Second Exemplary Embodiment

### Electronic Substrate

One embodiment of an electronic substrate according to a second exemplary embodiment contains the resin and the copolymer according to the first exemplary embodiment.

One embodiment of the electronic substrate according to the exemplary embodiment contains an electronic substrate material according to the second exemplary embodiment.

The electronic substrates can be broadly classified into a semiconductor substrate and an electronic circuit board.

### (1) Semiconductor Substrate

A semiconductor substrate is a substrate for forming a wiring layer for inputting and outputting electrical signals to and from chips, such as logic ICs, memories, and sensors. This wiring layer serves as a connection layer when connecting chips of the same or different types during parallel arrangement or stacking. Examples of the chip types include flip-chip chip-scale package (FC-CSP), flip-chip ball grid array (FC-BGA), and fan-out wafer level package (FO-WLP).

### (2) Electronic Circuit Board

An electronic circuit board is a substrate having wiring layers formed to connect multiple electronic components such as semiconductors or capacitors. Types of the electronic circuit broad include multilayer boards (rigid and flexible) with stacked wiring.

### Electronic Substrate Material

An electronic substrate material according to the exemplary embodiment is used in the form of a coating liquid composition (varnish), a film, or a sheet in order to form an electronic substrate according to the exemplary embodiment. That is, the coating liquid composition (varnish), film, and sheet include the electronic substrate material according to the exemplary embodiment.

The electronic substrate material according to the exemplary embodiment is excellent in low dielectric properties, a low thermal expansion coefficient, and high heat resistance. The electronic substrate material according to the exemplary embodiment can provide a composition for a coating liquid having high solvent solubility for coating molding and low solution viscosity properties.

The electronic substrate material according to the exemplary embodiment contains a first resin.

### First Resin

In one embodiment of the electronic substrate material according to the exemplary embodiment, the first resin is at least one resin selected from the group consisting of polycarbonate, polyester, and polyester polycarbonate.

In the electronic substrate material according to the exemplary embodiment, the first resin is the resin or the copolymer according to the first exemplary embodiment.

### Inorganic Filler

The electronic substrate material according to the exemplary embodiment may further contain an inorganic component. In one embodiment of the electronic substrate material according to the exemplary embodiment, the inorganic component preferably includes at least one component selected from the group consisting of an inorganic filler, glass fibers, and glass cloth.

In the exemplary embodiment, the inorganic filler is preferably at least one filler selected from the group consisting of silica, boron nitride, aluminum nitride, silicon nitride, silicon carbide, zinc oxide, titanium oxide, aluminum oxide, magnesium oxide, aluminum hydroxide, and magnesium hydroxide. Silica as the inorganic filler is preferably at least one type of silica selected from the group consisting of spherical silica, pulverized silica, hollow silica, and fumed silica.

### Thermoplastic Resin (Third Resin)

The electronic substrate material according to the exemplary embodiment may further include a thermoplastic resin (sometimes referred to as a third resin). The third resin is a thermoplastic resin that is different from the first resin. As the third resin, for instance, any known thermoplastic resin can be used.

In one embodiment of the electronic substrate material according to the exemplary embodiment, a content ratio of the first resin in the electronic substrate material is 50 mass% or more.

### Coating Liquid Composition

The electronic substrate material according to the exemplary embodiment may be contained in a coating liquid composition.

The coating liquid composition in the exemplary embodiment contains the electronic substrate material, which is specifically the resin or the copolymer according to the first exemplary embodiment. The coating liquid composition according to the exemplary embodiment may be referred to as a varnish.

The coating liquid composition in the exemplary embodiment contains the electronic substrate material and an organic solvent.

During the forming process of the electronic substrate using the coating liquid composition, the solvent in the coating liquid composition is removed by heating.

The organic solvent of the coating liquid composition can be appropriately selected in consideration of the solubility of materials such as the resin or the copolymer according to the first exemplary embodiment, the drying rate after forming, the influence of residual solvent in the formed product, and hazards (fire or health hazards).

Examples of the organic solvent used for the coating liquid composition according to the exemplary embodiment include cyclic ethers (such as tetrahydrofuran (THF), dioxane, and dioxolane), cyclic ketones (such as cyclohexanone, cyclopentanone, and cycloheptanone), aromatic hydrocarbons (such as toluene, xylene, and chlorobenzene), ketones (such as methyl ethyl ketone (MEK) and methyl isobutyl ketone (MIBK)), halogenated hydrocarbons (such as dichloromethane and chloroform), esters (such as ethyl acetate, isopropyl acetate, isobutyl acetate, and butyl acetate), ethers (such as ethylene glycol dimethyl ether and ethylene glycol monoethyl ether), amides (such as N,N-dimethylformamide (DMF) and dimethylacetamide (DMAc)), and aprotic polar solvents (such as dimethyl sulfoxide (DMSO)).

In the coating liquid composition according to the exemplary embodiment, considering environmental and safety aspects, it is preferable that the organic solvent is an organic solvent other than halogenated hydrocarbons, i.e., a non-halogenated solvent. It is more preferable that the organic solvent is at least one solvent selected from the group consisting of toluene, cyclohexanone, methyl ethyl ketone, tetrahydrofuran, dioxolane, and cyclopentanone.

One embodiment of the coating liquid composition according to the exemplary embodiment contains the electronic substrate material and a non-halogenated solvent.

One embodiment of the coating liquid composition according to the exemplary embodiment contains the resin or the copolymer according to the first exemplary embodiment and a non-halogenated solvent.

The concentration of the resin or the copolymer according to the first exemplary embodiment in the coating liquid composition according to the second exemplary embodiment only needs to be a concentration that results in an appropriate viscosity for the intended use of the coating liquid composition. The concentration is preferably in a range from 0.1 mass% to 40 mass%.

The concentration of the resin or the copolymer according to the first exemplary embodiment in the coating liquid composition according to the second exemplary embodiment is more preferably 1 mass% or more, still more preferably 5 mass% or more.

The concentration of the resin or the copolymer according to the first exemplary embodiment in the coating liquid composition according to the second exemplary embodiment is more preferably 35 mass% or less, still more preferably 30 mass% or less.

When the concentration of the resin or the copolymer according to the first exemplary embodiment in the coating liquid composition according to the second exemplary embodiment is 40 mass% or less, the viscosity does not become excessively high, resulting in good coatability.

When the concentration of the resin or the copolymer according to the first exemplary embodiment in the coating liquid composition according to the second exemplary embodiment is 0.1 mass% or more, a moderate viscosity can be kept to form a homogeneous film. Moreover, when the concentration is 0.1 mass% or more, it is possible to shorten the drying time after applying the coating liquid composition, and it becomes easier to form a film with the target thickness.

The electronic substrate material according to the exemplary embodiment may be applied in a solution state, i.e., as a coating liquid composition, directly onto a core material or the like made from polyimide, epoxy resin, or the like. In this case also, an inorganic filler such as silica may be dispersed in the coating liquid composition. As a solvent for dispersing the inorganic filler in the coating liquid composition, for instance, toluene, cyclohexanone, and MEK are preferably used.

### Film

One embodiment of a film according to the exemplary embodiment contains the resin or the copolymer according to the first exemplary embodiment.

One embodiment of the film according to the exemplary embodiment contains the electronic substrate material according to the exemplary embodiment.

The film according to the exemplary embodiment can be produced by forming a film of the electronic substrate material according to the exemplary embodiment through thermoforming (e.g., melt extrusion molding) or by forming a film through solution casting.

As the film according to the exemplary embodiment, when it is desired to obtain a thin film (e.g., a thickness of several micrometers to several tens of micrometers), a film is preferably formed through solution casting.

In addition, for purposes such as reducing thermal expansion, the electronic substrate material may be impregnated into glass cloth to form a film or may be formed into a film with an inorganic filler such as silica dispersed therein. Further, for purposes such as improving dielectric properties and adjusting the modulus of elasticity, the electronic substrate material containing a known thermoplastic resin as the third resin may also be used when forming a film. In the case where the electronic substrate material according to the exemplary embodiment has crosslinking sites, when such an electronic substrate material is formed into a film by solution casting, it is also possible to control the degree of crosslinking by incorporating a curing material into the electronic substrate material and adjusting the heating temperature, thereby varying properties such as the elastic modulus of the film.

### Sheet

One embodiment of a sheet according to the exemplary embodiment contains the resin or the copolymer according to the first exemplary embodiment.

One embodiment of the sheet according to the exemplary embodiment contains the electronic substrate material according to the exemplary embodiment.

When the electronic substrate material according to the exemplary embodiment is used as a sheet, it can be made into a sheet by impregnating a base material or the like with the coating liquid composition (varnish) described above. Examples

Next, the invention will be described in more detail with reference to Examples and Comparatives. However, the invention is not limited to these Examples, and various modifications and applications can be made without departing from the idea of the invention.

### Production Examples: Preparation of Oligomer

### Production Example 1: Synthesis of 1,1-bis-(4-hydroxyphenyl)cyclohexane oligomer

In 1,080 mL of methylene chloride, 60.1 g (224 mmol) of 1,1-bis-(4-hydroxyphenyl)cyclohexane was suspended, and 66.0 g (667 mmol) of phosgene was added thereto. To this solution, a liquid in which 44.0 g (435 mmol) of triethylamine was dissolved in 120 mL of methylene chloride was added dropwise in a temperature range from 5 degrees C to 15 degrees C. Next, stirring was performed for 30 minutes, and methylene chloride was then distilled off until the concentration thereof reached a predetermined value. To the residual liquid, 210 mL of pure water, 1.2 g of concentrated hydrochloric acid, and 450 mg of hydrosulfite were added, and washing was performed. Subsequently, washing was repeated with 210 mL of pure water five times to obtain a methylene chloride solution of a 1,1-bis-(4-hydroxyphenyl)cyclohexane oligomer having chloroformate groups at molecular terminals. The obtained solution had a chloroformate concentration of 1.10 mol/L, a solid concentration of 0.222 kg/L, and an average number of repeating units of 1.04. Hereinafter, the obtained oligomer (bischloroformate) according to Production Example 1 is referred to as Z-CF.

### Production Example 2: Synthesis of 1,1-bis-(4-hydroxy-3-methylphenyl)cyclohexane oligomer

The oligomer (bischloroformate) according to Production Example 2 was produced in the same manner as in Production Example 1, except that 66.4 g (224 mmol) of 1,1-bis-(4-hydroxy-3-methylphenyl)cyclohexane was used in place of 1,1-bis-(4-hydroxyphenyl)cyclohexane. The obtained solution had a chloroformate concentration of 1.07 mol/L, a solid concentration of 0.232 kg/L, and an average number of repeating units of 1.07. Hereinafter, the obtained oligomer according to Production Example 2 is referred to as CZ-CF.

### Production Example 3: Synthesis of 1,1-bis-(4-hydroxyphenyl)-3,3,5-trimethylcyclohexane oligomer

The oligomer (bischloroformate) according to Production Example 3 was produced in the same manner as in Production Example 1, except that 69.5 g (224 mmol) of 1,1-bis-(4-hydroxyphenyl)-3,3,5-trimethylcyclohexane was used in place of 1,1-bis-(4-hydroxyphenyl)cyclohexane. The obtained solution had a chloroformate concentration of 1.07 mol/L, a solid concentration of 0.229 kg/L, and an average number of repeating units of 1.03. Hereinafter, the obtained oligomer according to Production Example 3 is referred to as TMC-CF.

### Production Example 4: Synthesis of 1,1-bis-(4-hydroxy-3-methylphenyl)-3,3,5-trimethylcyclohexane oligomer

The oligomer (bischloroformate) according to Production Example 4 was produced in the same manner as in Production Example 1, except that 75.8 g (224 mmol) of 1,1-bis-(4-hydroxy-3-methylphenyl)-3,3,5-trimethylcyclohexane was used in place of 1,1-bis-(4-hydroxyphenyl)cyclohexane. The obtained solution had a chloroformate concentration of 0.92 mol/L, a solid concentration of 0.223 kg/L, and an average number of repeating units of 1.06. Hereinafter, the obtained oligomer according to Production Example 4 is referred to as OCTMC-CF.

### Production Example 5: Synthesis of 1,1-bis-(4-hydroxy-3-methylphenyl)-cyclododecane oligomer

The oligomer (bischloroformate) according to Production Example 5 was produced in the same manner as in Production Example 1, except that 85.2 g (224 mmol) of 1,1-bis-(4-hydroxy-3-methylphenyl)-cyclododecane was used in place of 1,1-bis-(4-hydroxyphenyl)cyclohexane. The obtained solution had a chloroformate concentration of 0.84 mol/L, a solid concentration of 0.218 kg/L, and an average number of repeating units of 1.04. Hereinafter, the obtained oligomer according to Production Example 5 is referred to as OCCDE-CF.

### Synthesis Example 1

### Production of PC Polymer

Into a reaction vessel equipped with a mechanical stirrer, stirring blades, and baffles, 225 mL of Z-CF obtained in Production Example 1, 339 mL of methylene chloride, 38.9 g of 2,2'-methylenebis(6-cyclohexyl-p-cresol), and 0.235 g of p-tert-butylphenol were added, followed by stirring so as to be sufficiently mixed, thereby obtaining a methylene chloride solution (M1). Hereinafter, 2,2'-methylenebis(6-cyclohexyl-p-cresol) and p-tert-butylphenol may be referred to as MBCC and PTBP, respectively.

Separately, 864 mL of 2.0 N aqueous potassium hydroxide solution (containing 23.3 g of potassium hydroxide) was cooled to room temperature or lower, and then 0. 23 g of sodium hydrosulfite, and 0.33 g of benzyltripropylammonium chloride were added and completely dissolved, thereby obtaining an aqueous sodium hydroxide solution (SH1).

To the methylene chloride solution (M1) was added the whole amount of the aqueous sodium hydroxide solution (SH1), followed by addition of an aqueous triethylamine solution (7 vol%, 2.52 mL) with stirring, and stirring was then continued for 1 hour.

The resulting reaction mixture after stirring was diluted with 0.72 L of methylene chloride and 0.04 L of water, and washing (first washing) was performed. After the first washing, the lower layer was separated and further washed with 0.23 L of water once, with 0.23 L of 0.03 N hydrochloric acid once, and with 0.23 L of water three times in this order (second washing). After the second washing, the resulting methylene chloride solution was added dropwise into methanol with stirring, and the resulting reprecipitated substance was filtered and dried to obtain a PC polymer (PC-1) having a structure below.

### Identification of PC Polymer

The PC polymer (PC-1) thus obtained was dissolved in methylene chloride to prepare a solution with a concentration of 0.5 g/dL, and a reduced viscosity [ηsp/C] at 20 degrees C was measured. The reduced viscosity was 0.69 dL/g.

The structure and composition of the obtained PC polymer (PC-1) were analyzed by ¹H-NMR spectroscopy. The results confirmed that the PC polymer (PC-1) was a PC polymer having repeating units as represented by a formula (PC-1) below.

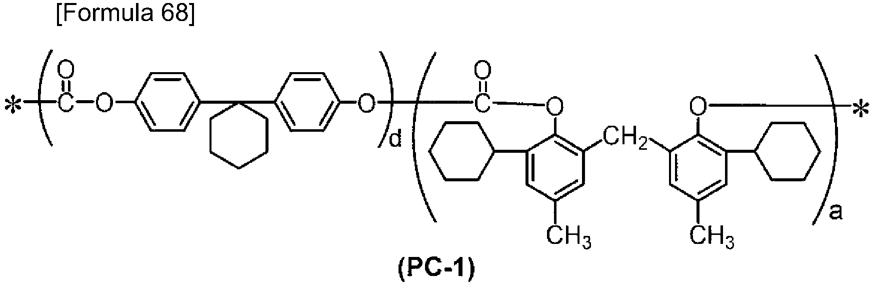

In the PC polymer (PC-1) according to Synthesis Example 1, a repeating unit [Z] derived from the oligomer Z-CF according to Production Example 1 included the structural unit represented by the formula (B1) and the structural unit represented by the formula (D1), and a repeating unit [MBCC] derived from the monomer MBCC included the structural unit represented by the formula (A1) and the structural unit represented by the formula (B1). As the composition ratio of the repeating units in the PC polymer (PC-1), the mole fraction d of the repeating unit [Z] was 60 mol%, and the mole fraction a of the repeating unit [MBCC] was 40 mol%.

### Synthesis Example 2

### Production of PC Polymer

A PC polymer (PC-2) having a structure below was obtained in the same manner as in Synthesis Example 1, except that the oligomer CZ-CF obtained in Production Example 2 was used in place of the oligomer Z-CF.

### Identification of PC Polymer

The PC polymer (PC-2) thus obtained was dissolved in methylene chloride to prepare a solution with a concentration of 0.5 g/dL, and a reduced viscosity [ηsp/C] at 20 degrees C was measured. The reduced viscosity was 0.64 dL/g.

The structure and composition of the obtained PC polymer (PC-2) were analyzed by ¹H-NMR spectroscopy. The results confirmed that the PC polymer (PC-2) was a PC polymer having repeating units and a composition as represented by a formula (PC-2) below.

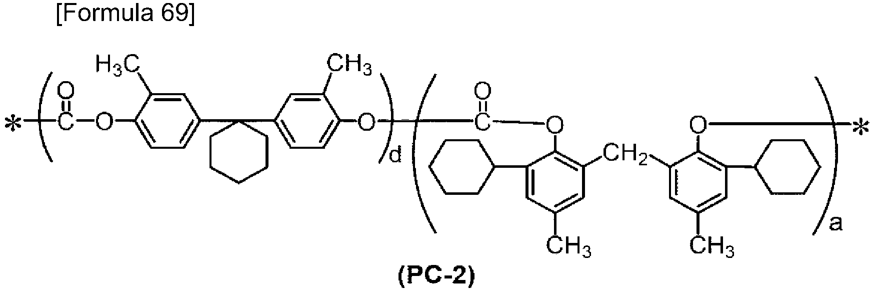

In the PC polymer (PC-2), a repeating unit [CZ] derived from the oligomer CZ-CF according to Production Example 2 included the structural unit represented by the formula (B1) and the structural unit represented by the formula (D1), and the repeating unit [MBCC] derived from the monomer MBCC included the structural unit represented by the formula (A1) and the structural unit represented by the formula (B1). As the composition ratio of the repeating units in the PC polymer (PC-2), the mole fraction d of the repeating unit [CZ] was 60 mol%, and the mole fraction a of the repeating unit [MBCC] was 40 mol%.

### Synthesis Example 3

### Production of PC Polymer

A PC polymer (PC-3) having a structure below was obtained in the same manner as in Synthesis Example 1, except that the oligomer TMC-CF obtained in Production Example 3 was used in place of the oligomer Z-CF.

### Identification of PC Polymer

The PC polymer (PC-3) thus obtained was dissolved in methylene chloride to prepare a solution with a concentration of 0.5 g/dL, and a reduced viscosity [ηsp/C] at 20 degrees C was measured. The reduced viscosity was 0.42 dL/g.

The structure and composition of the obtained PC polymer (PC-3) were analyzed by ¹H-NMR spectroscopy. The results confirmed that the PC polymer (PC-3) was a PC polymer having repeating units and a composition as represented by a formula (PC-3) below.

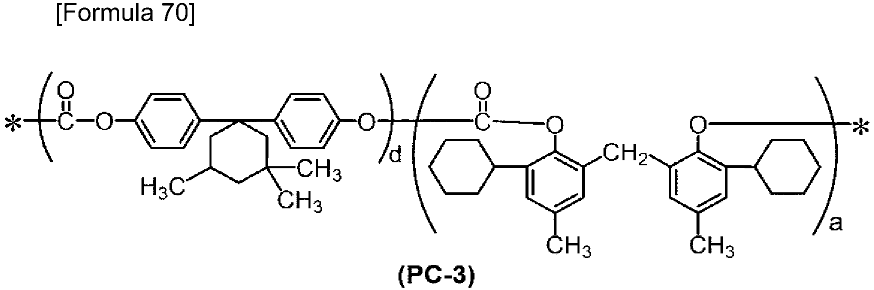

In the PC polymer (PC-3), a repeating unit [TMC] derived from the oligomer TMC-CF according to Production Example 3 included the structural unit represented by the formula (B1) and the structural unit represented by the formula (D1), and the repeating unit [MBCC] derived from the monomer MBCC included the structural unit represented by the formula (A1) and the structural unit represented by the formula (B1). As the composition ratio of the repeating units in the PC polymer (PC-3), the mole fraction d of the repeating unit [TMC] was 60 mol%, and the mole fraction a of the repeating unit [MBCC] was 40 mol%.

### Synthesis Example 4

### Production of PC Polymer

A PC polymer (PC-4) having a structure below was obtained in the same manner as in Synthesis Example 1, except that the oligomer OCTMC-CF obtained in Production Example 4 was used in place of the oligomer Z-CF.

### Identification of PC Polymer

The PC polymer (PC-4) thus obtained was dissolved in methylene chloride to prepare a solution with a concentration of 0.5 g/dL, and a reduced viscosity [ηsp/C] at 20 degrees C was measured. The reduced viscosity was 0.68 dL/g.

The structure and composition of the obtained PC polymer (PC-4) were analyzed by ¹H-NMR spectroscopy. The results confirmed that the PC polymer (PC-4) was a PC polymer having repeating units and a composition as represented by a formula (PC-4) below.

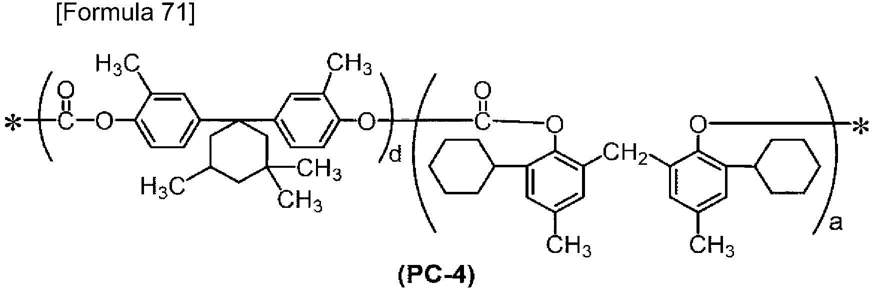

In the PC polymer (PC-4), a repeating unit [OCTMC] derived from the oligomer OCTMC-CF according to Production Example 4 included the structural unit represented by the formula (B1) and the structural unit represented by the formula (D1), and the repeating unit [MBCC] derived from the monomer MBCC included the structural unit represented by the formula (A1) and the structural unit represented by the formula (B1). As the composition ratio of the repeating units in the PC polymer (PC-4), the mole fraction d of the repeating unit [OCTMC] was 60 mol%, and the mole fraction a of the repeating unit [MBCC] was 40 mol%.

### Synthesis Example 5

### Production of PC Polymer

A PC polymer (PC-5) having a structure below was obtained in the same manner as in Synthesis Example 1, except that the oligomer OCCDE-CF obtained in Production Example 5 was used in place of the oligomer Z-CF.

### Identification of PC Polymer

The PC polymer (PC-5) thus obtained was dissolved in methylene chloride to prepare a solution with a concentration of 0.5 g/dL, and a reduced viscosity [ηsp/C] at 20 degrees C was measured. The reduced viscosity was 0.63 dL/g.

The structure and composition of the obtained PC polymer (PC-5) were analyzed by ¹H-NMR spectroscopy. The results confirmed that the PC polymer (PC-5) was a PC polymer having repeating units and a composition as represented by a formula (PC-5) below.

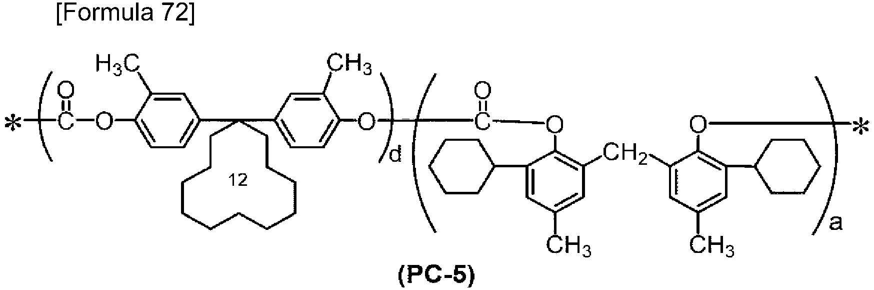

In the PC polymer (PC-5), a repeating unit [OCCDE] derived from the oligomer OCCDE-CF according to Production Example 5 included the structural unit represented by the formula (B1) and the structural unit represented by the formula (D1), and the repeating unit [MBCC] derived from the monomer MBCC included the structural unit represented by the formula (A1) and the structural unit represented by the formula (B1). As the composition ratio of the repeating units in the PC polymer (PC-5), the mole fraction d of the repeating unit [OCCDE] was 60 mol%, and the mole fraction a of the repeating unit [MBCC] was 40 mol%.

### Preparation of Coating Liquid Composition Including Polycarbonate Resin and Preparation of Resin Film

### Example 1

In a sample tube with a screw cap, 1.1 g of the PC polymer (PC-1) was weighed and dissolved in 6 g of tetrahydrofuran to obtain a coating liquid composition. The resulting coating liquid composition was applied to a glass plate by casting using an applicator with a gap of 500 µm to form a film. The film was air-dried for one hour and dried under reduced pressure in a vacuum dryer at a temperature of 50 degrees C for 8 hours and then at a temperature of 110 degrees C for 8 hours to remove the solvent, thereby obtaining a resin film having a thickness of 50 to 100 µm according to Example 1.

### Example 2

A resin film according to Example 2 was obtained in the same manner as in Example 1, except that the PC polymer (PC-2) was used in place of the PC polymer (PC-1).

### Example 3

A resin film according to Example 3 was obtained in the same manner as in Example 1, except that the PC polymer (PC-3) was used in place of the PC polymer (PC-1).

### Example 4

A resin film according to Example 4 was obtained in the same manner as in Example 1, except that the PC polymer (PC-4) was used in place of the PC polymer (PC-1).

### Example 5

A resin film according to Example 5 was obtained in the same manner as in Example 1, except that the PC polymer (PC-5) was used in place of the PC polymer (PC-1).

### Comparative 1

A resin film according to Comparative 1 was obtained in the same manner as in Example 1, except that a polycarbonate resin (Z-PC) made from 1,1-bis-(4-hydroxyphenyl)cyclohexane was used in place of the PC polymer (PC-1). The polycarbonate resin (Z-PC) had a repeating unit below, and its reduced viscosity [ηsp/C] at 20 degrees C was 0.91 dL/g.

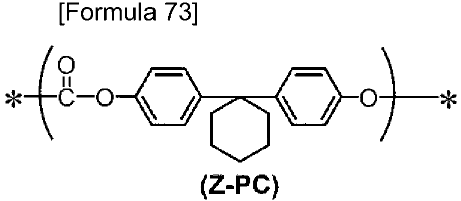

### Comparative 2

A resin film according to Comparative 2 was obtained in the same manner as in Example 1, except that a polycarbonate resin (CZ-PC) made from 1,1-bis-(4-hydroxy-3-methylphenyl)cyclohexane was used in place of the PC polymer (PC-1). The polycarbonate resin (CZ-PC) had a repeating unit below, and its reduced viscosity [ηsp/C] at 20 degrees C was 0.75 dL/g.

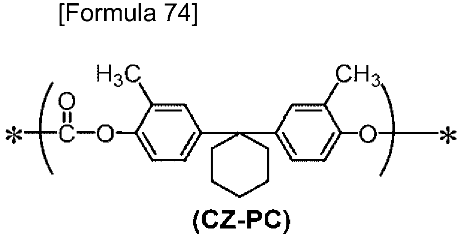

### Comparative 3

A resin film according to Comparative 3 was obtained in the same manner as in Example 1, except that a polycarbonate resin (TMC-PC) made from 1,1-bis-(4-hydroxyphenyl)-3,3,5-trimethylcyclohexane was used in place of the PC polymer (PC-1). The polycarbonate resin (TMC-PC) had a repeating unit below, and its reduced viscosity [ηsp/C] at 20 degrees C was 0.42 dL/g.

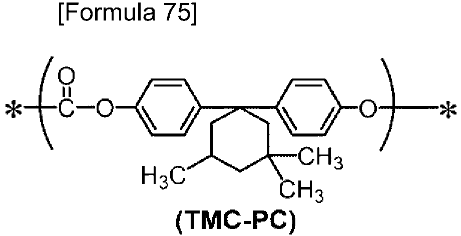

### Comparative 4

A resin film according to Comparative 4 was obtained in the same manner as in Example 1, except that a polycarbonate resin (OCTMC-PC) made from 1,1-bis-(4-hydroxy-3-methylphenyl)-3,3,5-trimethylcyclohexane was used in place of the PC polymer (PC-1). The polycarbonate resin (OCTMC-PC) had a repeating unit below, and its reduced viscosity [ηsp/C] at 20 degrees C was 0.47 dL/g.

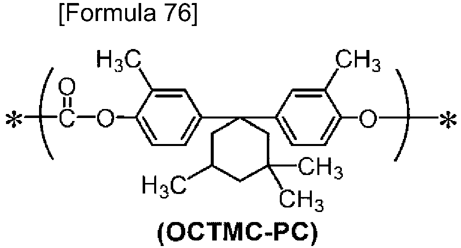

### Comparative 5

A resin film according to Comparative 5 was obtained in the same manner as in Example 1, except that a polycarbonate resin (OCCDE-PC) made from 1,1-bis-(4-hydroxy-3-methylphenyl)-cyclododecane was used in place of the PC polymer (PC-1). The polycarbonate resin (OCCDE-PC) had a repeating unit below, and its reduced viscosity [ηsp/C] at 20 degrees C was 0.70 dL/g.

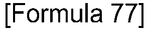

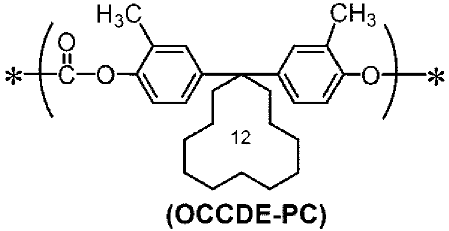

### Evaluation of Physical Properties of Polycarbonate Resin

The physical properties of the polycarbonate resin (PC polymer) were evaluated by the following methods.

### Reduced Viscosity [ηsp/C]

A solution having a concentration of 0.5 g/dL was prepared by dissolving a polycarbonate resin in methylene chloride serving as a solvent, and the reduced viscosity [ηsp/C] of this solution was measured. The reduced viscosity [ηsp/C] of this methylene chloride solution was measured at 20 ± 0.01 degrees C using an Ubbelohde viscometer. A flow time of the solvent alone was 72.4 seconds.

### Viscosity-Average Molecular Weight Mv

The viscosity-average molecular weight (Mv) was calculated according to the following Schnell's equation, by preparing a polymer solution through dissolving a polycarbonate resin in methylene chloride serving as a solvent, measuring the intrinsic viscosity [η] of the solution at 20 degrees C using an Ubbelohde viscometer, and using the measured value in the equation.$\left[η\right] = 1.23 \times {10}^{- 5} {Mv}^{0.83}$

For the measurement of the intrinsic viscosity [η], a viscometer (manufactured by Rigosha & Co., Ltd., product name: RIGO AUTO VISCOMETER/VRM-052USPC) was used. The polymer solution used in the measurement was prepared by adding 40 mL of methylene chloride to 200 mg of the polycarbonate resin and dissolving the polycarbonate resin.

### Evaluation of Dielectric Constant and Dissipation Factor

A square film having 60 mm in length and 60 mm in width was cut out from the resin film and conditioned for 24 hours at a room temperature of 22 ± 1 degrees C and humidity of 33 ± 5%. The dielectric constant (Dk) and the dissipation factor (Df) were then measured at a frequency of 10 GHz using a split cylinder resonator (manufactured by EM labs, Inc.) and a network analyzer (manufactured by Keysight Technologies, Inc.) The obtained results are shown in Table 1.

### Evaluation of Solubility in Non-Halogenated Solvents (Toluene, Methyl Ethyl Ketone, Cyclohexanone)

In a sample tube, 0.5 g (20 mass%) or 0.105 g (5 mass%) of the resin film and 2.0 g of toluene, methyl ethyl ketone (MEK), or cyclohexanone were placed and stirred at room temperature to prepare a solution. After 24 hours, the appearance of the solution was visually confirmed. The obtained results are shown in Table 1.
A: In the solution with a concentration of 20 mass%, no insoluble matter was observed, and the solution was transparent.
B: In the solution with a concentration of 20 mass%, turbidity was visually observed; and in the solution with a concentration of 5 mass%, no insoluble matter was observed, and the solution was transparent.
C: In both the 20 mass% solution and the 5 mass% solution, insoluble matter was present.

### Evaluation of Glass Transition Temperature and Thermal Expansion Coefficient

A strip of film having 40 mm in length and 4 mm in width was cut out from the resin film, and measurement was performed using TMA (manufactured by Hitachi High-Tech Science Corporation, product name: TMA7100). The obtained results are shown in Table 1.
Measurement mode: Tensile
Temperature condition: -30 degrees C to 320 degrees C
Heating rate: 5 degrees C/min
Data processing method: The coefficient of thermal expansion (CTE) was calculated in a range from 40 degrees C to 100 degrees C, and the glass transition temperature (Tg) was determined using an inflection point temperature.

**Table 1**

| | PC Resin | | | | Dielectric Properties | | Thermal Properties | | Solubility (A/B/C) | | |
|---|---|---|---|---|---|---|---|---|---|---|---|
| | Name | Repeating unit | Reduced viscosity [ηsp/C] (dL/g) | Viscosity-average molecular weight Mv | Dk | Df | Tg (°C) | CTE (ppm/K) | MEK | Cyclo-hexanone | Toluene |
| Ex. 1 | PC-1 | [MBCC] and [Z] | 0.69 | 29,100 | 2.55 | 0.00146 | 171 | 74 | A | A | A |
| Ex. 2 | PC-2 | [MBCC] and [CZ] | 0.64 | 26,900 | 2.63 | 0.00218 | 166 | 82 | A | A | A |
| Ex. 3 | PC-3 | [MBCC] and [TMC] | 0.42 | 16,900 | 2.48 | 0.00132 | 193 | 73 | A | A | A |
| Ex. 4 | PC-4 | [MBCC] and [OCTMC] | 0.68 | 28,900 | 2.49 | 0.00107 | 195 | 76 | A | A | A |
| Ex. 5 | PC-5 | [MBCC] and [OCCDE] | 0.63 | 26,200 | 2.51 | 0.00129 | 199 | 87 | A | A | A |
| Comp. 1 | Z-PC | [Z] | 0.91 | 39,600 | 2.73 | 0.00380 | 204 | 74 | C | A | A |
| Comp. 2 | CZ-PC | [CZ] | 0.75 | 32,200 | 2.67 | 0.00177 | 142 | 93 | A | A | A |
| Comp. 3 | TMC-PC | [TMC] | 0.42 | 16,700 | 2.58 | 0.00456 | 237 | 65 | A | B | A |
| Comp. 4 | OCTMC-PC | [OCTMC] | 0.47 | 18,800 | 2.52 | 0.00172 | 204 | 87 | A | A | A |
| Comp. 5 | OCCDE-PC | [OCCDE] | 0.70 | 29,000 | 2.49 | 0.00145 | 215 | 72 | A | B | A |

The polycarbonate resins according to Examples 1 to 5, which included the structural unit represented by the formula (A1) in the repeating units, were well dissolved in methyl ethyl ketone, cyclohexanone, and toluene which were non-halogenated solvents, at a specific concentration, and exhibited good solubility in a plurality of types of non-halogenated solvents. On the other hand, the polycarbonate resin according to Comparative 1 was not dissolved in methyl ethyl ketone, and the polycarbonate resins according to Comparative 3 and Comparative 5 exhibited inferior solubility in cyclohexanone as compared with Examples 1 to 5. The polycarbonate resin according to Comparative 4 exhibited inferior dielectric properties as compared with Example 4. The polycarbonate resin according to Comparative 2 exhibited inferior thermal properties as compared with Example 2.

Further, the polycarbonate resins according to Examples 1 to 5 had dielectric properties enabling use as an electronic substrate material. Accordingly, the resin according to one embodiment of the invention is suitable for solution processing using a non-halogenated solvent without impairing the dielectric properties and thermal properties of the resin.

## Claims

1. An electronic substrate material, comprising:
a first resin, wherein
the first resin is at least one resin selected from the group consisting of polycarbonate, polyester, and polyester polycarbonate, and
the first resin includes a structural unit represented by a formula (A1) below and at least one structural unit selected from the group consisting of structural units represented by formulae (B1), (C1), and (D1) below, 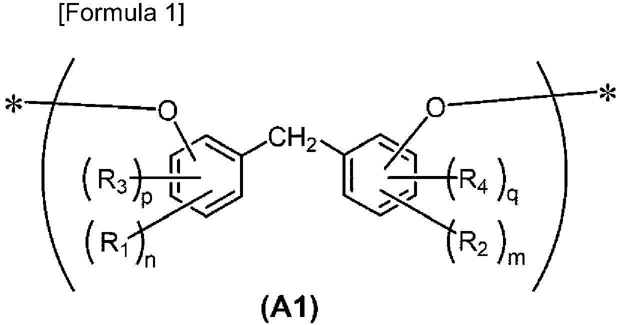 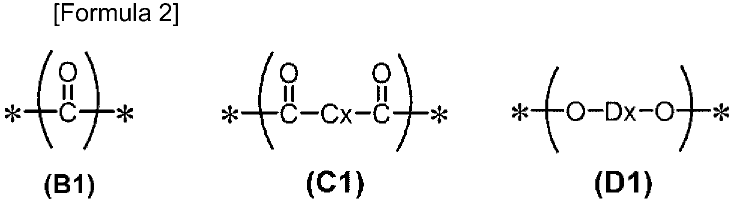
where, in the formula (A1):
R₁ and R₂ are each independently a substituted or unsubstituted cycloalkyl group having 3 to 20 ring carbon atoms;
n represents 1, 2, 3, or 4, and a plurality of R₁ are identical or different from each other;
m represents 1, 2, 3, or 4, and a plurality of R₂ are identical or different from each other;
R₃ and R₄ are each independently a substituted or unsubstituted alkyl group having 1 to 20 carbon atoms, a substituted or unsubstituted alkenyl group having 2 to 10 carbon atoms, a substituted or unsubstituted alkynyl group having 2 to 10 carbon atoms, a substituted or unsubstituted aryl group having 6 to 14 ring carbon atoms, a substituted or unsubstituted alkoxy group having 1 to 20 carbon atoms, a substituted or unsubstituted cycloalkoxy group having 3 to 20 ring carbon atoms, a substituted or unsubstituted aryloxy group having 6 to 14 ring carbon atoms, a substituted or unsubstituted aralkyl group having 7 to 20 carbon atoms, a substituted or unsubstituted aralkyloxy group having 7 to 20 carbon atoms, a substituted or unsubstituted heteroaryl group having 5 to 14 ring atoms, a halogen atom, a nitro group, an aldehyde group, a cyano group, or a carboxy group;
p represents 0, 1, 2, or 3, and a plurality of R₃ are identical or different from each other;
q represents 0, 1, 2, or 3, and a plurality of R₄ are identical or different from each other;
a sum of n and p is 1, 2, 3, or 4;
a sum of m and q is 1, 2, 3, or 4; and
the structural unit represented by the formula (B1) is different from a carbonyl group in the formula (C1);
in the formula (C1):
Cx is a divalent group including at least one group selected from the group consisting of a substituted or unsubstituted divalent aromatic hydrocarbon group, a substituted or unsubstituted divalent cyclic aliphatic hydrocarbon group, and a substituted or unsubstituted divalent acyclic aliphatic hydrocarbon group;
in the formula (D1):
Dx is a divalent group including at least one group selected from the group consisting of a substituted or unsubstituted divalent aromatic hydrocarbon group, a substituted or unsubstituted divalent cyclic aliphatic hydrocarbon group, and a substituted or unsubstituted divalent acyclic aliphatic hydrocarbon group;
the structural unit represented by the formula (A1) and the structural unit represented by the formula (D1) are different from each other;
substituents for a "substituted or unsubstituted" group are bonded to each other to form a monocyclic ring, bonded to each other to form a fused ring, or not bonded to each other;
each * in the formulae (A1), (B1), (C1) and (D1) represents a bond;
when the first resin includes a plurality of structural units represented by the formula (A1), the plurality of structural units represented by the formula (A1) are identical or different from each other;
when the first resin includes a plurality of structural units represented by the formula (C1), the plurality of structural units represented by the formula (C1) are identical or different from each other; and
when the first resin includes a plurality of structural units represented by the formula (D1), the plurality of structural units represented by the formula (D1) are identical or different from each other.

2. The electronic substrate material according to claim 1, wherein
the first resin is a resin including the structural units represented by the formulae (A1) and (B1).

3. The electronic substrate material according to claim 1, wherein
the first resin is a resin including the structural units represented by the formulae (A1), (B1), and (D1).

4. The electronic substrate material according to any one of claims 1 to 3, wherein
a ratio a:d of a mole fraction a of the structural unit represented by the formula (A1) to a mole fraction d of the structural unit represented by the formula (D1) in the first resin is in a range from 5:95 to 100:0.

5. The electronic substrate material according to claim 3 or 4, wherein
a ratio a:d of a mole fraction a of the structural unit represented by the formula (A1) to a mole fraction d of the structural unit represented by the formula (D1) in the first resin is in a range from 10:90 to 50:50.

6. The electronic substrate material according to any one of claims 1 to 5, wherein
the structural unit represented by the formula (A1) is represented by a formula (A10) below, 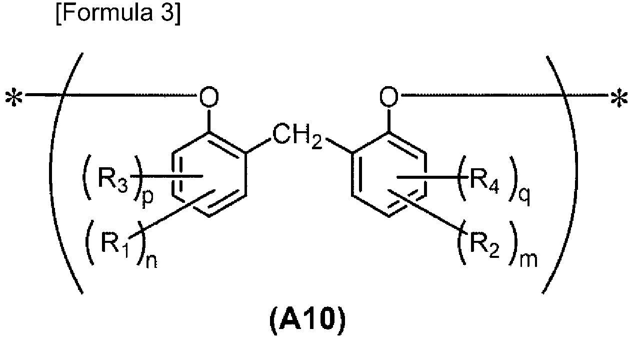
where, in the formula (A10), R₁, R₂, R₃, R₄, n, m, p, q, and * respectively represent the same as R₁, R₂, R₃, R₄, n, m, p, q, and * in the formula (A1).

7. The electronic substrate material according to any one of claims 1 to 6, wherein
n and m are each 1.

8. The electronic substrate material according to any one of claims 1 to 7, wherein
the structural unit represented by the formula (A1) is represented by a formula (A11) below, 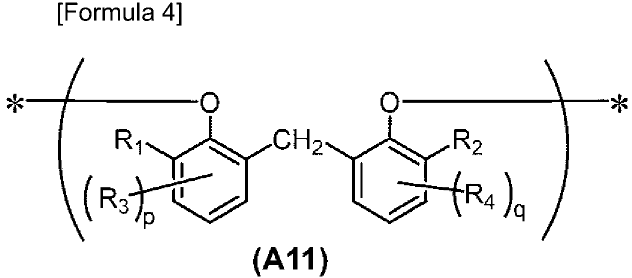
where, in the formula (A11), R₁, R₂, R₃, R₄, p, q, and * respectively represent the same as R₁, R₂, R₃, R₄, p, q, and * in the formula (A1).

9. The electronic substrate material according to any one of claims 1 to 8, wherein
p and q are each 1.

10. The electronic substrate material according to any one of claims 1 to 9, wherein
the structural unit represented by the formula (A1) is represented by a formula (A12) below, 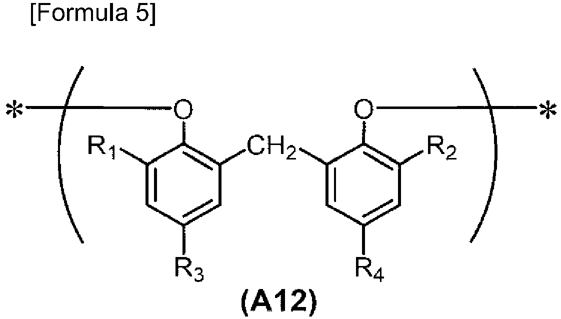
where, in the formula (A12), R₁, R₂, R₃, R₄, and * respectively represent the same as R₁, R₂, R₃, R₄, and * in the formula (A1).

11. The electronic substrate material according to any one of claims 1 to 10, wherein
the structural unit represented by the formula (D1) is represented by a formula (D2) below, 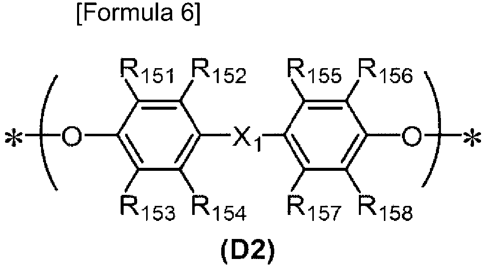
where, in the formula (D2):
R₁₅₁ to R₁₅₈ are each independently selected from the group consisting of a hydrogen atom, a halogen atom, a substituted or unsubstituted alkyl group having 1 to 18 carbon atoms, a substituted or unsubstituted alkoxy group having 1 to 18 carbon atoms, a substituted or unsubstituted cycloalkyl group having 6 to 20 ring carbon atoms, a substituted or unsubstituted cycloalkoxy group having 6 to 20 ring carbon atoms, a substituted or unsubstituted alkenyl group having 2 to 10 carbon atoms, a substituted or unsubstituted aryl group having 6 to 14 ring carbon atoms, a substituted or unsubstituted aryloxy group having 6 to 14 ring carbon atoms, a substituted or unsubstituted aralkyl group having 7 to 20 carbon atoms, a substituted or unsubstituted aralkyloxy group having 7 to 20 carbon atoms, a nitro group, an aldehyde group, a cyano group, and a carboxy group;
X₁ is (i) a single bond; (ii) a group selected from the group consisting of a substituted or unsubstituted alkylene group having 1 to 28 carbon atoms, a substituted or unsubstituted alkylidene group having 2 to 28 carbon atoms, a substituted or unsubstituted cycloalkylene group having 5 to 15 ring carbon atoms, a substituted or unsubstituted cycloalkylidene group having 3 to 26 ring carbon atoms, a substituted or unsubstituted arylene group having 6 to 20 ring carbon atoms, -S-, - SO-, -SO₂-, -O-, and -CO-; or (iii) a divalent group formed by linking two or more groups selected from the group described in (ii) above; and
each * represents a bond.

12. The electronic substrate material according to claim 11, wherein
X₁ is a substituted or unsubstituted cycloalkylidene group having 5 to 15 ring carbon atoms.

13. The electronic substrate material according to claim 11 or 12, wherein
R₁₅₁ to R₁₅₈ are each independently a hydrogen atom, a substituted or unsubstituted alkyl group having 1 to 18 carbon atoms, or a substituted or unsubstituted cycloalkyl group having 6 to 20 ring carbon atoms.

14. The electronic substrate material according to any one of claims 1 to 10, wherein
the structural unit represented by the formula (D1) is represented by a formula (D3) below, 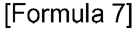 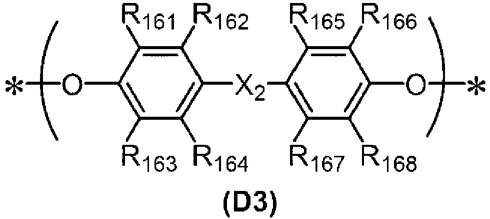
where, in the formula (D3):
X₂ is (i) a single bond, or (ii) a substituted or unsubstituted divalent organic group having 7 to 12 carbon atoms;
R₁₆₁ to R₁₆₈ are each independently a hydrogen atom, or a substituted or unsubstituted organic group having 1 to 10 carbon atoms; and
each * represents a bond.

15. The electronic substrate material according to any one of claims 1 to 14, wherein
a reduced viscosity of the first resin is 0.80 dL/g or less, and
the reduced viscosity of the first resin is a reduced viscosity at 20 degrees C of a solution having a concentration of 0.5 g/dL, in which methylene chloride is used as a solvent and the first resin is used as a solute.

16. The electronic substrate material according to any one of claims 1 to 15, wherein
the first resin includes a repeating unit represented by a formula (PC-AB1) below in which the structural unit represented by the formula (A1) is bonded to the structural unit represented by the formula (B1), and
consecutive repeating units each represented by the formula (PC-AB1) are absent in the first resin, 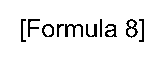 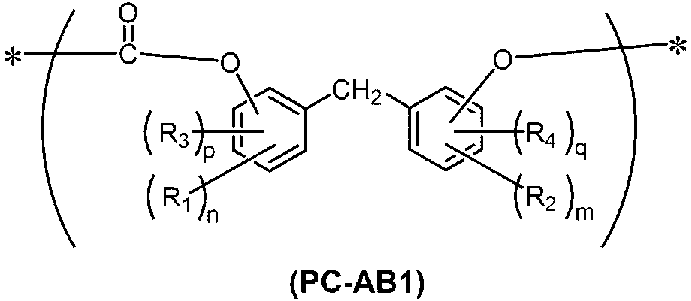
where, in the formula (PC-AB1), R₁, R₂, R₃, R₄, m, n, p, and q respectively represent the same as R₁, R₂, R₃, R₄, m, n, p, and q in the formula (A1), and each * represents a bond.

17. The electronic substrate material according to any one of claims 1 to 16, wherein
the first resin is a polycarbonate resin.

18. The electronic substrate material according to any one of claims 1 to 17, wherein
a content ratio of the first resin in the electronic substrate material is 50 mass% or more.

19. The electronic substrate material according to any one of claims 1 to 18, wherein
a dielectric constant Dk of the first resin is 2.70 or less.

20. The electronic substrate material according to any one of claims 1 to 19, wherein
a dissipation factor Df of the first resin is 0.00300 or less.

21. The electronic substrate material according to any one of claims 1 to 20, wherein
a viscosity-average molecular weight Mv of the first resin in the electronic substrate material is in a range from 1,000 to 30,000.

22. A coating liquid composition, comprising:
the electronic substrate material according to any one of claims 1 to 21; and
a non-halogenated solvent.

23. A film comprising the electronic substrate material according to any one of claims 1 to 21.

24. A sheet comprising the electronic substrate material according to any one of claims 1 to 21.

25. An electronic substrate comprising the electronic substrate material according to any one of claims 1 to 21.

26. A resin that is at least one resin selected from the group consisting of polycarbonate, polyester, and polyester polycarbonate, the resin comprising:
a structural unit represented by a formula (A1) below and at least one structural unit selected from the group consisting of structural units represented by formulae (B1), (C1), and (D1) below, 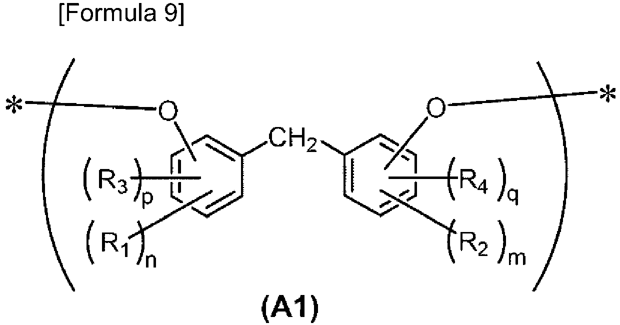 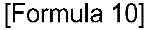 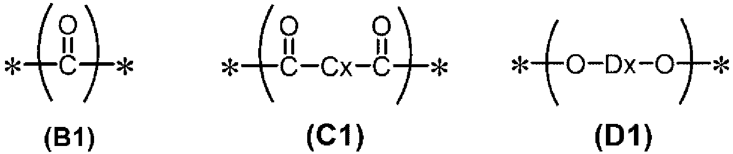
where, in the formula (A1):
R₁ and R₂ are each independently a substituted or unsubstituted cycloalkyl group having 3 to 20 ring carbon atoms;
n represents 1, 2, 3, or 4, and a plurality of R₁ are identical or different from each other;
m represents 1, 2, 3, or 4, and a plurality of R₂ are identical or different from each other;
R₃ and R₄ are each independently a substituted or unsubstituted alkyl group having 1 to 20 carbon atoms, a substituted or unsubstituted alkenyl group having 2 to 10 carbon atoms, a substituted or unsubstituted alkynyl group having 2 to 10 carbon atoms, a substituted or unsubstituted aryl group having 6 to 14 ring carbon atoms, a substituted or unsubstituted alkoxy group having 1 to 20 carbon atoms, a substituted or unsubstituted cycloalkoxy group having 3 to 20 ring carbon atoms, a substituted or unsubstituted aryloxy group having 6 to 14 ring carbon atoms, a substituted or unsubstituted aralkyl group having 7 to 20 carbon atoms, a substituted or unsubstituted aralkyloxy group having 7 to 20 carbon atoms, a substituted or unsubstituted heteroaryl group having 5 to 14 ring atoms, a halogen atom, a nitro group, an aldehyde group, a cyano group, or a carboxy group;
p represents 0, 1, 2, or 3, and a plurality of R₃ are identical or different from each other;
q represents 0, 1, 2, or 3, and a plurality of R₄ are identical or different from each other;
a sum of n and p is 1, 2, 3, or 4;
a sum of m and q is 1, 2, 3, or 4; and
the structural unit represented by the formula (B1) is different from a carbonyl group in the formula (C1);
in the formula (C1):
Cx is a divalent group including at least one group selected from the group consisting of a substituted or unsubstituted divalent aromatic hydrocarbon group, a substituted or unsubstituted divalent cyclic aliphatic hydrocarbon group, and a substituted or unsubstituted divalent acyclic aliphatic hydrocarbon group;
in the formula (D1):
Dx is a divalent group including at least one group selected from the group consisting of a substituted or unsubstituted divalent aromatic hydrocarbon group, a substituted or unsubstituted divalent cyclic aliphatic hydrocarbon group, and a substituted or unsubstituted divalent acyclic aliphatic hydrocarbon group;
the structural unit represented by the formula (A1) and the structural unit represented by the formula (D1) are different from each other;
substituents for a "substituted or unsubstituted" group are bonded to each other to form a monocyclic ring, bonded to each other to form a fused ring, or not bonded to each other;
each * in the formulae (A1), (B1), (C1) and (D1) represents a bond;
when the resin includes a plurality of structural units represented by the formula (A1), the plurality of structural units represented by the formula (A1) are identical or different from each other;
when the resin includes a plurality of structural units represented by the formula (C1), the plurality of structural units represented by the formula (C1) are identical or different from each other; and
when the resin includes a plurality of structural units represented by the formula (D1), the plurality of structural units represented by the formula (D1) are identical or different from each other.

27. The resin according to claim 26, wherein
the resin is a resin including the structural units represented by the formulae (A1) and (B1).

28. The resin according to claim 26, wherein
the resin is a resin including the structural units represented by the formulae (A1), (B1), and (D1).

29. The resin according to any one of claims 26 to 28, wherein
a ratio a:d of a mole fraction a of the structural unit represented by the formula (A1) to a mole fraction d of the structural unit represented by the formula (D1) in the resin is in a range from 5:95 to 100:0.

30. The resin according to claim 28 or 29, wherein
a ratio a:d of a mole fraction a of the structural unit represented by the formula (A1) to a mole fraction d of the structural unit represented by the formula (D1) in the resin is in a range from 10:90 to 50:50.

31. The resin according to any one of claims 26 to 30, wherein
the structural unit represented by the formula (A1) is represented by a formula (A10) below, 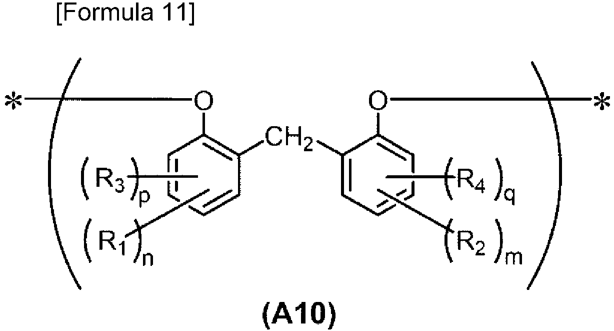
where, in the formula (A10), R₁, R₂, R₃, R₄, n, m, p, q, and * respectively represent the same as R₁, R₂, R₃, R₄, n, m, p, q, and * in the formula (A1).

32. The resin according to any one of claims 26 to 31, wherein
n and m are each 1.

33. The resin according to any one of claims 26 to 32, wherein
the structural unit represented by the formula (A1) is represented by a formula (A11) below, 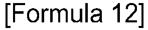 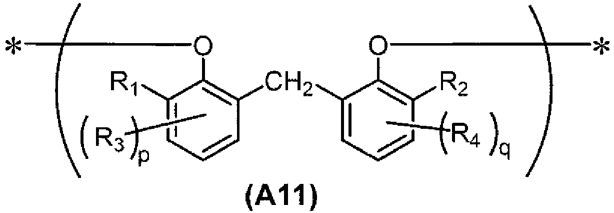
where, in the formula (A11), R₁, R₂, R₃, R₄, p, q, and * respectively represent the same as R₁, R₂, R₃, R₄, p, q, and * in the formula (A1).

34. The resin according to any one of claims 26 to 33, wherein
p and q are each 1.

35. The resin according to any one of claims 26 to 34, wherein
the structural unit represented by the formula (A1) is represented by a formula (A12) below, 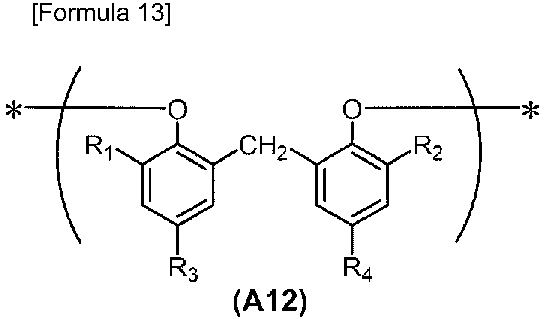
where, in the formula (A12), R₁, R₂, R₃, R₄, and * respectively represent the same as R₁, R₂, R₃, R₄, and * in the formula (A1).

36. The resin according to any one of claims 26 to 35, wherein
the structural unit represented by the formula (D1) is represented by a formula (D2) below, 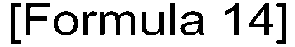 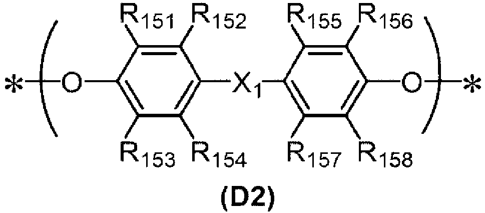
where, in the formula (D2):
R₁₅₁ to R₁₅₈ are each independently selected from the group consisting of a hydrogen atom, a halogen atom, a substituted or unsubstituted alkyl group having 1 to 18 carbon atoms, a substituted or unsubstituted alkoxy group having 1 to 18 carbon atoms, a substituted or unsubstituted cycloalkyl group having 6 to 20 ring carbon atoms, a substituted or unsubstituted cycloalkoxy group having 6 to 20 ring carbon atoms, a substituted or unsubstituted alkenyl group having 2 to 10 carbon atoms, a substituted or unsubstituted aryl group having 6 to 14 ring carbon atoms, a substituted or unsubstituted aryloxy group having 6 to 14 ring carbon atoms, a substituted or unsubstituted aralkyl group having 7 to 20 carbon atoms, a substituted or unsubstituted aralkyloxy group having 7 to 20 carbon atoms, a nitro group, an aldehyde group, a cyano group, and a carboxy group;
X₁ is (i) a single bond; (ii) a group selected from the group consisting of a substituted or unsubstituted alkylene group having 1 to 28 carbon atoms, a substituted or unsubstituted alkylidene group having 2 to 28 carbon atoms, a substituted or unsubstituted cycloalkylene group having 5 to 15 ring carbon atoms, a substituted or unsubstituted cycloalkylidene group having 3 to 26 ring carbon atoms, a substituted or unsubstituted arylene group having 6 to 20 ring carbon atoms, -S-, - SO-, -SO₂-, -O-, and -CO-; or (iii) a divalent group formed by linking two or more groups selected from the group described in (ii) above; and
each * represents a bond.

37. The resin according to claim 36, wherein
X₁ is a substituted or unsubstituted cycloalkylidene group having 5 to 15 ring carbon atoms.

38. The resin according to claim 36 or 37, wherein
R₁₅₁ to R₁₅₈ are each independently a hydrogen atom, a substituted or unsubstituted alkyl group having 1 to 18 carbon atoms, or a substituted or unsubstituted cycloalkyl group having 6 to 20 ring carbon atoms.

39. The resin according to any one of claims 26 to 35, wherein
the structural unit represented by the formula (D1) is represented by a formula (D3) below, 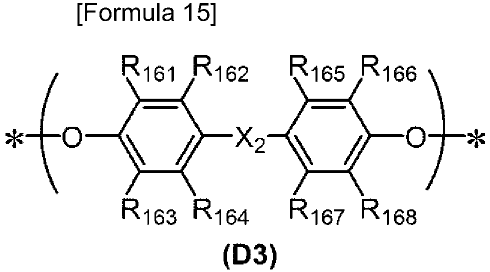
where, in the formula (D3):
X₂ is (i) a single bond, or (ii) a substituted or unsubstituted divalent organic group having 7 to 12 carbon atoms;
R₁₆₁ to R₁₆₈ are each independently a hydrogen atom, or a substituted or unsubstituted organic group having 1 to 10 carbon atoms; and
each * represents a bond.

40. The resin according to any one of claims 26 to 39, wherein
a reduced viscosity of the resin is 0.80 dL/g or less, and
the reduced viscosity of the resin is a reduced viscosity at 20 degrees C of a solution having a concentration of 0.5 g/dL, in which methylene chloride is used as a solvent and the resin is used as a solute.

41. The resin according to any one of claims 26 to 40, wherein
the resin includes a repeating unit represented by a formula (PC-AB1) below in which the structural unit represented by the formula (A1) is bonded to the structural unit represented by the formula (B1), and
consecutive repeating units each represented by the formula (PC-AB1) are absent in the resin, 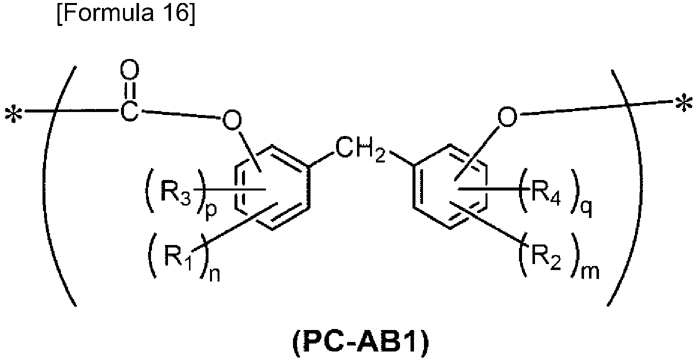
where, in the formula (PC-AB1), R₁, R₂, R₃, R₄, m, n, p, and q respectively represent the same as R₁, R₂, R₃, R₄, m, n, p, and q in the formula (A1), and each * represents a bond.

42. The resin according to any one of claims 26 to 38, wherein
the resin is a polycarbonate resin.

43. The resin according to any one of claims 26 to 42, wherein
a dielectric constant Dk of the resin is 2.70 or less.

44. The resin according to any one of claims 26 to 43, wherein
a dissipation factor Df of the resin is 0.00300 or less.

45. The resin according to any one of claims 26 to 44, wherein
a viscosity-average molecular weight Mv of the resin is in a range from 1,000 to 30,000.

46. A coating liquid composition, comprising:
the resin according to any one of claims 26 to 45; and
a non-halogenated solvent.

47. A film comprising the resin according to any one of claims 26 to 45.

48. A sheet comprising the resin according to any one of claims 26 to 45.

49. An electronic substrate comprising the resin according to any one of claims 26 to 45.

50. A resin production method for producing the resin according to any one of claims 26 to 45, comprising:
polymerizing the resin using a composition represented by a formula (MA1) below, wherein
the polymerizing is performed without causing the compound represented by the formula (MA1) to coexist with phosgene, 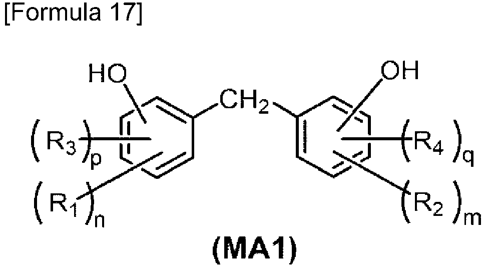
where, in the formula (MA1), R₁, R₂, R₃, R₄, m, n, p, and q respectively represent the same as R₁, R₂, R₃, R₄, m, n, p, and q in the formula (A1).
